# EUROPEAN PATENT APPLICATION

(11) **EP 4 716 444 A1**
(43) Date of publication of application: **25.03.2026**
(21) Application number: 25193769.4
(22) Date of filing: 04.08.2025
(51) Int. Cl.: H10P 72/00

(54) **SUBSTRATE PROCESSING APPARATUS AND SUBSTRATE PROCESSING METHOD**

(30) Priority: 19.09.2024 JP 2024162619
(71) Applicant: SCREEN Holdings Co., Ltd., Kyoto-shi, Kyoto 602-8585 (JP)
(72) Inventor: KUWAHARA, Joji, Kyoto, 602-8585 (JP); NISHIYAMA, Koji, Kyoto, 602-8585 (JP)
(74) Representative: Kilian Kilian & Partner mbB

(57) **Abstract**

The present invention relates to a substrate processing apparatus and a substrate processing method. A substrate processing apparatus includes an indexer portion, a slider portion, a bridge portion, a first front portion, and a first rear portion. The indexer portion, the slider portion, and the bridge portion are arranged in this order in a front-rear direction. The first front portion, the bridge portion, and the first rear portion are arranged in this order in the front-rear direction. The slider portion transports a substrate between the indexer portion and the bridge portion. The bridge portion transports the substrate between the slider portion and the first front portion. The bridge portion transports the substrate between the slider portion and the first rear portion. The first front portion includes a plurality of processing units. The first front portion includes a transport mechanism. The first rear portion includes a plurality of processing units. The first rear portion includes a transport mechanism. The slider portion overlaps with the processing units of the first front portion in plan view.

## Description

### BACKGROUND OF THE INVENTION

### 1. TECHNICAL FIELD

The present invention relates to a substrate processing apparatus and a substrate processing method for processing a substrate. The substrate is, for example, any of a semiconductor wafer, a substrate for a liquid crystal display, a substrate for organic electroluminescence (EL), a substrate for a flat panel display (FPD), a substrate for an optical display, a substrate for a magnetic disk, a substrate for an optical disk, a substrate for a magneto-optical disk, a substrate for a photomask, and a substrate for a solar cell.

### 2. DESCRIPTION OF THE RELATED ART

JP 2008-258208 A discloses a substrate processing apparatus. Hereinafter, reference numerals described in JP 2008-258208 A are written in parentheses. A substrate processing apparatus includes a carrier block (S1), a first processing block (S2), a delivery block (S3), a second processing block (S4), and a shuttle arm (G1, G2). The first processing block (S2) includes a processing unit and a main arm (A11). The second processing block (S4) includes a processing unit and a main arm (A21). The shuttle arm (G1) is disposed upward of the main arm (A11). The shuttle arm (G2) is disposed upward of the main arm (A21).

### SUMMARY OF THE INVENTION

There is a need for further improving throughput of a substrate processing apparatus.

The present invention has been made in view of such a circumstance, and an object thereof is to provide a substrate processing apparatus and a substrate processing method capable of improving throughput of the substrate processing apparatus.

In order to achieve such an object, the present invention has the following configuration. That is, the present invention provides a substrate processing apparatus including: an indexer portion; a slider portion; a bridge portion; a first front portion; and a first rear portion, in which the indexer portion, the slider portion, and the bridge portion are arranged in this order in a first direction, the first direction is horizontal, the first front portion, the bridge portion, and the first rear portion are arranged in this order in the first direction, the slider portion transports a substrate between the indexer portion and the bridge portion, the bridge portion transports a substrate between the slider portion and the first front portion, and transports a substrate between the slider portion and the first rear portion, the first front portion includes: a plurality of processing units; and a first front transport mechanism configured to transport a substrate to each of the processing units of the first front portion, the first rear portion includes: a plurality of processing units; and a first rear transport mechanism configured to transport a substrate to each of the processing units of the first rear portion, and the slider portion overlaps with the processing units of the first front portion in plan view.

The substrate processing apparatus includes the indexer portion, the slider portion, the bridge portion, the first front portion, and the first rear portion. The indexer portion, the slider portion, and the bridge portion are arranged in this order in the first direction. The first direction is horizontal. The first front portion, the bridge portion, and the first rear portion are arranged in this order in the first direction. The slider portion transports a substrate between the indexer portion and the bridge portion. The bridge portion transports a substrate between the slider portion and the first front portion. The bridge portion transports a substrate between the slider portion and the first rear portion. The first front portion includes the plurality of processing units. The first front portion includes the first front transport mechanism. The first front transport mechanism transports a substrate to each of the processing units of the first front portion. The first rear portion includes the plurality of processing units. The first rear portion includes the first rear transport mechanism. The first rear transport mechanism transports a substrate to each of the processing units of the first rear portion.

Here, the slider portion overlaps with the processing units of the first front portion in plan view. Therefore, it is easy to arrange the processing units of the first front portion and the first front transport mechanism at high density. Thus, it is easy to improve throughput of the first front portion. That is, it is easy to efficiently process a substrate in the first front portion.

In summary, according to the substrate processing apparatus, it is easy to improve throughput.

It is preferred in the substrate processing apparatus described above that the slider portion does not overlap with the first front transport mechanism in plan view. Therefore, it is easy to arrange the processing units of the first front portion and the first front transport mechanism at high density. Thus, it is easy to improve throughput of the first front portion.

It is preferred in the substrate processing apparatus described above that the slider portion does not overlap with the first rear portion in plan view. Therefore, it is easy to arrange the processing units of the first front portion and the first front transport mechanism at high density. Thus, it is easy to improve throughput of the first rear portion.

It is preferred in the substrate processing apparatus described above that a substrate always passes through the slider portion and the bridge portion when a substrate is transported from the indexer portion to the first front portion, and a substrate always passes through the slider portion and the bridge portion when a substrate is transported from the first front portion to the indexer portion. Therefore, a substrate is efficiently transported between the indexer portion and the first front portion. Thus, it is easy to improve throughput of the substrate processing apparatus.

It is preferred in the substrate processing apparatus described above that a substrate always passes through the slider portion and the bridge portion when a substrate is transported from the indexer portion to the first rear portion, and a substrate always passes through the slider portion and the bridge portion when a substrate is transported from the first rear portion to the indexer portion. Therefore, a substrate is efficiently transported between the indexer portion and the first rear portion. Thus, it is easy to improve throughput of the substrate processing apparatus.

It is preferred in the substrate processing apparatus described above that the first front transport mechanism is configured to move to a height position same as a height position of the slider portion. Therefore, it is easy to expand a movable range of the first front transport mechanism in a vertical direction. Thus, it is easy to improve throughput of the first front portion.

It is preferred in the substrate processing apparatus described above that the processing units of the first front portion include a first processing unit and a plurality of second processing units, the first processing unit of the first front portion and the slider portion are arranged in a vertical direction, the second processing units of the first front portion are arranged in a vertical direction, and at least one of the second processing units of the first front portion is disposed at a height position same as a height position of the slider portion. The processing units of the first front portion include the first processing unit. The first processing unit of the first front portion and the slider portion are arranged in the vertical direction. Therefore, it is easy for the slider portion to overlap with the processing unit of the first front portion in plan view.

The processing units of the first front portion include the plurality of second processing units. The second processing units of the first front portion are arranged in the vertical direction. At least one of the second processing units of the first front portion is disposed at a height position same as a height position of the slider portion. Therefore, the processing units of the first front portion and the first front transport mechanism are arranged at high density. Furthermore, it is easy to increase the number of the second processing units of the first front portion. Thus, it is easy to improve throughput of the first front portion.

It is preferred in the substrate processing apparatus described above that the first processing unit of the first front portion, the first front transport mechanism, and the second processing units of the first front portion are arranged in this order in a second direction, and the second direction is horizontal and is orthogonal to the first direction. Therefore, the first front transport mechanism efficiently transports a substrate to the first processing unit of the first front portion. The first front transport mechanism efficiently transports a substrate to each of the second processing units of the first front portion. Thus, it is easy to improve throughput of the first front portion.

It is preferred in the substrate processing apparatus described above that the first processing unit of the first front portion performs non-liquid processing on a substrate, and the second processing units of the first front portion perform liquid processing on a substrate. Therefore, it is easy to perform non-liquid processing and liquid processing on a substrate in the first front portion.

It is preferred in the substrate processing apparatus described above that the processing units of the first front portion include a third processing unit, and the third processing unit of the first front portion and the first front transport mechanism are arranged in the first direction. The processing units of the first front portion include the third processing unit. Therefore, it is easy to increase the number of the processing units of the first front portion.

The third processing unit of the first front portion and the first front transport mechanism are arranged in the first direction. Therefore, the first front transport mechanism efficiently transports a substrate to the third processing unit of the first front portion.

It is preferred in the substrate processing apparatus described above that the substrate processing apparatus includes: a second front portion disposed upward of the first front portion, in which the second front portion includes: a plurality of processing units; and a second front transport mechanism configured to transport a substrate to each of the processing units of the second front portion, the slider portion overlaps with the processing units of the second front portion in plan view, and the slider portion is disposed between the first front portion and the second front portion. The substrate processing apparatus includes the second front portion. The second front portion includes the plurality of processing units. The second front portion includes the second front transport mechanism. The second front transport mechanism transports a substrate to each of the processing units of the second front portion. Therefore, it is easy to improve throughput of the substrate processing apparatus.

The slider portion overlaps with the processing units of the second front portion in plan view. Therefore, it is easy to arrange the processing units of the second front portion and the second front transport mechanism at high density. Thus, it is easy to improve throughput of the second front portion.

The slider portion is disposed between the first front portion and the second front portion. Therefore, the slider portion and the first front portion are adjacent to each other. The slider portion and the second front portion are adjacent to each other. Thus, it is easy for the bridge portion to transport a substrate between the slider portion and the first front portion. It is easy for the bridge portion to transport a substrate between the slider portion and the second front portion.

It is preferred in the substrate processing apparatus described above that the slider portion does not overlap with the second front transport mechanism in plan view. Therefore, it is easy to arrange the processing units of the second front portion and the second front transport mechanism at high density. Thus, it is easy to improve throughput of the second front portion.

It is preferred in the substrate processing apparatus described above that the slider portion includes: a lower portion; and an upper portion located upward of the lower portion of the slider portion, the first front transport mechanism is configured to move to a height position same as a height position of the lower portion of the slider portion, and the second front transport mechanism is configured to move to a height position same as a height position of the upper portion of the slider portion. The slider portion has the lower portion. The first front transport mechanism is configured to move to a height position same as a height position of the lower portion of the slider portion. Therefore, it is easy to expand a movable range of the first front transport mechanism in the vertical direction. Thus, it is easy to improve throughput of the first front portion.

The slider portion has the upper portion. The upper portion of the slider portion is located upward of the lower portion of the slider portion. The second front transport mechanism is configured to move to a height position same as a height position of the upper portion of the slider portion. Therefore, it is easy to expand a movable range of the second front transport mechanism in the vertical direction. Thus, it is easy to improve throughput of the second front portion.

It is preferred in the substrate processing apparatus described above that the processing units of the second front portion include a first processing unit and a plurality of second processing units, the first processing unit of the second front portion is disposed upward of the first processing unit of the first front portion, the slider portion is disposed upward of the first processing unit of the first front portion and downward of the first processing unit of the second front portion, the second processing units of the second front portion are disposed upward of the second processing units of the first front portion, the second processing units of the second front portion are arranged in a vertical direction, at least one of the second processing units of the first front portion is disposed at a height position same as a height position of the lower portion of the slider portion, and at least one of the second processing units of the second front portion is disposed at a height position same as a height position of the upper portion of the slider portion. The processing units of the second front portion include the first processing unit. The first processing unit of the second front portion is disposed upward of the first processing unit of the first front portion. The slider portion is disposed upward of the first processing unit of the first front portion and downward of the first processing unit of the second front portion. Therefore, it is easy for the slider portion to overlap with the processing unit of the first front portion in plan view. It is easy for the slider portion to overlap with the processing unit of the second front portion in plan view. It is easy to dispose the slider portion between the first front portion and the second front portion.

At least one of the second processing units of the first front portion is disposed at a height position same as a height position of the lower portion of the slider portion. Therefore, it is easy to dispose at least one of the second processing units of the first front portion at a height position same as a height position of the slider portion.

The processing units of the second front portion include the plurality of second processing units. The second processing units of the second front portion are arranged in the vertical direction. At least one of the second processing units of the second front portion is disposed at a height position same as a height position of the slider portion. Therefore, the processing units of the second front portion and the second front transport mechanism are arranged at high density. Furthermore, it is easy to increase the number of the second processing units of the second front portion. Thus, it is easy to improve throughput of the second front portion.

It is preferred in the substrate processing apparatus described above that the indexer portion includes a first transport mechanism, the slider portion includes a second transport mechanism, the bridge portion includes a third transport mechanism, the first transport mechanism and the second transport mechanism deliver a substrate to each other, the second transport mechanism and the third transport mechanism deliver a substrate to each other, the first transport mechanism includes a first support portion configured to support a substrate, the second transport mechanism includes a second support portion configured to support a substrate, the third transport mechanism includes a third support portion configured to support a substrate, and, when the first transport mechanism and the second transport mechanism deliver a substrate to each other, the second support portion overlaps with the processing units of the first front portion in plan view. The indexer portion includes the first transport mechanism. The slider portion includes the second transport mechanism. The bridge portion includes the third transport mechanism. The first transport mechanism and the second transport mechanism deliver a substrate to each other. The second transport mechanism and the third transport mechanism deliver a substrate to each other. Therefore, it is easy for the slider portion to transport a substrate between the indexer portion and the bridge portion.

The first transport mechanism includes the first support portion configured to support the substrate. The second transport mechanism includes the second support portion configured to support the substrate. The third transport mechanism includes the third support portion configured to support the substrate. Therefore, it is easy for the first transport mechanism and the second transport mechanism to deliver a substrate to each other. It is easy for the second transport mechanism and the third transport mechanism to deliver a substrate to each other.

When the first transport mechanism and the second transport mechanism deliver a substrate to each other, the second support portion overlaps with the processing units of the first front portion in plan view. Therefore, a transport distance of the substrate in the slider portion is short. Thus, the slider portion efficiently transports a substrate between the indexer portion and the bridge portion.

It is preferred in the substrate processing apparatus described above that, when the second transport mechanism and the third transport mechanism deliver a substrate to each other, the second support portion overlaps with the processing units of the first front portion in plan view. Therefore, a transport distance of the substrate in the slider portion is short. Thus, the slider portion efficiently transports a substrate between the indexer portion and the bridge portion.

It is preferred in the substrate processing apparatus described above that the first transport mechanism and the second transport mechanism deliver a plurality of substrates to each other at a time, and the second transport mechanism and the third transport mechanism deliver a plurality of substrates to each other at a time. The first transport mechanism and the second transport mechanism deliver a plurality of substrates to each other at a time. Therefore, the first transport mechanism and the second transport mechanism efficiently deliver substrates to each other.

The second transport mechanism and the third transport mechanism deliver a plurality of substrates to each other at a time. Therefore, the second transport mechanism and the third transport mechanism efficiently deliver substrates to each other.

It is preferred in the substrate processing apparatus described above that the first support portion includes a plurality of first hands, each of the first hands supports one substrate, the second support portion includes a plurality of second hands, each of the second hands supports one substrate, the third support portion includes a plurality of third hands, and each of the third hands supports one substrate. Therefore, it is easy for the first transport mechanism and the second transport mechanism to deliver a plurality of substrates to each other at a time. It is easy for the second transport mechanism and the third transport mechanism to deliver a plurality of substrates to each other at a time.

It is preferred in the substrate processing apparatus described above that the second transport mechanism includes a guide configured to guide the second support portion, the guide has a closed curved shape, and the second support portion circularly moves along the guide. Therefore, the slider portion efficiently transports a substrate between the indexer portion and the bridge portion.

It is preferred in the substrate processing apparatus described above that the slider portion includes: a detector configured to detect a substrate supported by the second support portion. Therefore, it is easy to monitor transport of a substrate in the slider portion.

It is preferred in the substrate processing apparatus described above that the detector is unmovable, and the detector detects a substrate supported by the second support portion when the second transport mechanism transports a substrate. The detector is unmovable. Therefore, it is easy to install the detector.

When the second transport mechanism transports a substrate, the detector detects a substrate supported by the second support portion. When the second transport mechanism transports a substrate, a relative position between the substrate and the detector changes. Therefore, even when the detector is unmovable, it is easy for the detector to detect a substrate supported by the second support portion.

It is preferred that the substrate processing apparatus described above includes a controller configured to control at least one of the first transport mechanism, the second transport mechanism, or the third transport mechanism based on a detection result of the detector. Therefore, the second support portion appropriately supports a substrate. Thus, the slider portion appropriately transports a substrate between the indexer portion and the bridge portion.

It is preferred in the substrate processing apparatus described above that the slider portion includes an inspection portion configured to inspect a substrate supported by the second support portion. Thus, it is easy to improve throughput of the substrate processing apparatus.

It is preferred in the substrate processing apparatus described above that the inspection portion is unmovable, and the inspection portion inspects a substrate supported by the second support portion when the second transport mechanism transports a substrate. The inspection portion is unmovable. Therefore, it is easy to install the inspection portion.

The inspection portion inspects a substrate supported by the second support portion when the second transport mechanism transports a substrate. When the second transport mechanism transports a substrate, a relative position between the substrate and the inspection portion changes. Therefore, even when the inspection portion is unmovable, it is easy for the inspection portion to inspect a substrate supported by the second support portion.

The present invention provides a substrate processing method including: a first step of transporting a substrate from an indexer portion to a slider portion; a second step of transporting a substrate from the slider portion to a bridge portion; a third step of transporting a substrate from the bridge portion to a first front portion; a fourth step of transporting a substrate from the bridge portion to a first rear portion; a front transport step of transporting a substrate to a processing unit of the first front portion by using a first front transport mechanism of the first front portion, the processing unit overlapping with the slider portion in plan view; and a rear transport step of transporting a substrate to a processing unit of the first rear portion by using a first rear transport mechanism of the first rear portion.

In other words, the present invention provides a substrate processing method including: transporting a substrate from an indexer portion to a slider portion; transporting a substrate from the slider portion to a bridge portion; transporting a substrate from the bridge portion to a first front portion; transporting a substrate from the bridge portion to a first rear portion; transporting a substrate to a processing unit of the first front portion by using a first front transport mechanism of the first front portion, the processing unit overlapping with the slider portion in plan view; and transporting a substrate to a processing unit of the first rear portion by using a first rear transport mechanism of the first rear portion.

The substrate processing method includes the first step, the second step, the third step, the fourth step, the front transport step, and the rear transport step. In the first step, a substrate is transported from the indexer portion to the slider portion. In the second step, a substrate is transported from the slider portion to the bridge portion. In the third step, a substrate is transported from the bridge portion to the first front portion. In the fourth step, a substrate is transported from the bridge portion to the first rear portion. In the front transport step, the first front transport mechanism of the first front portion transports a substrate to the processing unit of the first front portion. In the rear transport step, the first rear transport mechanism of the first rear portion transports a substrate to the processing unit of the first rear portion.

Here, the processing unit of the first front portion overlap with the slider portion in plan view. Therefore, it is easy to arrange the processing unit of the first front portion and the first front transport mechanism at high density. Thus, it is easy to improve throughput of the first front portion. That is, it is easy to efficiently process a substrate in the first front portion.

When a substrate is transported from the indexer portion to the first front portion, the first step, the second step, and the third step are executed. Therefore, a substrate is efficiently transported from the indexer portion to the first front portion. Thus, it is easy to improve throughput of the first front portion.

When a substrate is transported from the indexer portion to the first rear portion, the first step, the second step, and the fourth step are executed. Therefore, a substrate is efficiently transported from the indexer portion to the first rear portion. Thus, it is easy to improve throughput of the first rear portion.

In summary, according to the substrate processing method, it is easy to improve throughput.

It is preferred in the substrate processing method that the slider portion does not overlap with the first front transport mechanism in plan view. Therefore, it is easy to arrange the processing unit of the first front portion and the first front transport mechanism at high density. Thus, it is easy to improve throughput of the first front portion.

It is preferred that the substrate processing method includes: a fifth step of transporting a substrate from the first front portion to the bridge portion; a sixth step of transporting a substrate from the first rear portion to the bridge portion; a seventh step of transporting a substrate from the bridge portion to the slider portion; and an eighth step of transporting a substrate from the slider portion to the indexer portion.

In other words, it is preferred that the substrate processing method includes: transporting a substrate from the first front portion to the bridge portion; transporting a substrate from the first rear portion to the bridge portion; transporting a substrate from the bridge portion to the slider portion; and transporting a substrate from the slider portion to the indexer portion.

The substrate processing method includes the fifth step, the sixth step, the seventh step, and the eighth step. In the fifth step, a substrate is transported from the first front portion to the bridge portion. In the sixth step, a substrate is transported from the first rear portion to the bridge portion. In the seventh step, a substrate is transported from the bridge portion to the slider portion. In the eighth step, a substrate is transported from the slider portion to the indexer portion.

Here, when a substrate is transported from the first front portion to the indexer portion, the fifth step, the seventh step, and the eighth step are executed. Therefore, a substrate is efficiently transported from the first front portion to the indexer portion. Thus, it is easy to improve throughput of the first front portion.

When a substrate is transported from the first rear portion to the indexer portion, the sixth step, the seventh step, and the eighth step are executed. Therefore, a substrate is efficiently transported from the first rear portion to the indexer portion. Thus, it is easy to improve throughput of the first rear portion.

In summary, according to the substrate processing method, it is easy to improve throughput.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a schematic side view of a substrate processing apparatus according to an embodiment;
FIG. 2 is a control block diagram of the substrate processing apparatus;
FIG. 3 is a diagram schematically illustrating a transport path of a substrate;
FIG. 4 is a plan view of the substrate processing apparatus;
FIG. 5 is a plan view of the substrate processing apparatus;
FIG. 6 is a plan view of the substrate processing apparatus;
FIG. 7 is a first side view of the substrate processing apparatus;
FIG. 8 is a second side view of the substrate processing apparatus;
FIG. 9 is a front view of an indexer portion;
FIG. 10 is a front view of a slider portion, a first front portion, and a second front portion;
FIG. 11 is a front view of a bridge portion;
FIG. 12 is a front view of a first rear portion and a second rear portion;
FIG. 13 is a detailed front view of the indexer portion;
FIG. 14 is a detailed plan view of the slider portion;
FIG. 15 is a detailed plan view of a part of the bridge portion;
FIG. 16 is a diagram schematically illustrating a transport path of a substrate;
FIG. 17 is a side view schematically illustrating an operation example of the substrate processing apparatus;
FIG. 18 is a front view of a bridge portion according to a modified embodiment;
FIG. 19 is a side view of a slider portion according to a modified embodiment;
FIG. 20 is a plan view of a slider portion according to a modified embodiment;
FIG. 21 is a side view of a slider portion according to the modified embodiment;
FIG. 22 is a plan view of a slider portion according to the modified embodiment;
FIG. 23 is a plan view of a slider portion according to the modified embodiment; and
FIG. 24 is a plan view of a slider portion according to a modified embodiment.

### DETAILED DESCRIPTION

Hereinafter, a substrate processing apparatus and a substrate processing method of the present invention will be described with reference to the drawings.

### <1. Outline of substrate processing apparatus>

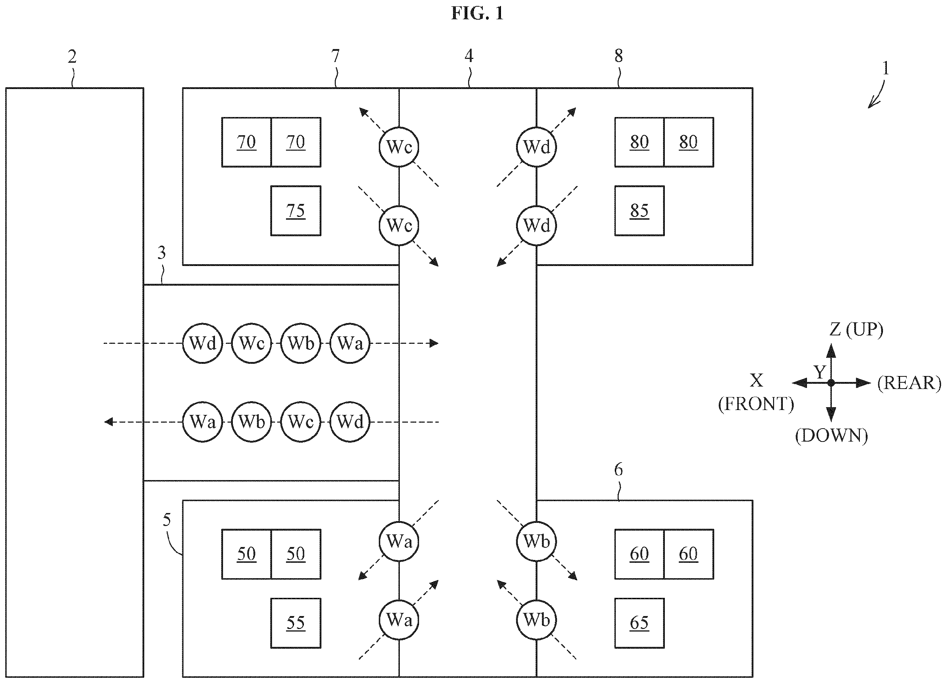

FIG. 1 is a schematic side view of a substrate processing apparatus 1 according to an embodiment. The substrate processing apparatus 1 processes a substrate W.

The substrate W is, for example, a semiconductor wafer, a substrate for a liquid crystal display, a substrate for organic electroluminescence (EL), a substrate for a flat panel display (FPD), a substrate for an optical display, a substrate for a magnetic disk, a substrate for a magneto-optical disk, a substrate for a photomask, or a substrate for a solar cell. The substrate W has a thin flat plate shape. The substrate W has a substantially circular shape in plan view.

The substrate processing apparatus 1 includes an indexer portion 2, a slider portion 3, and a bridge portion 4. The indexer portion 2, the slider portion 3, and the bridge portion 4 are arranged in this order in a front-rear direction X.

The front-rear direction X is horizontal. In the present specification, a direction from the bridge portion 4 toward the slider portion 3 in the front-rear direction X is referred to as "frontward". A direction opposite to the frontward is referred to as "rearward". A width direction Y is horizontal. The width direction Y is orthogonal to the front-rear direction X. One direction in the width direction Y is referred to as a "first side". A direction opposite to the first side is referred to as a "second side". A vertical direction Z is orthogonal to the front-rear direction X. The vertical direction Z is orthogonal to the width direction Y. The vertical direction Z includes "upward" and "downward". In each figure, the frontward is indicated by "FRONT" for reference. The rearward is indicated by "REAR". The first side is indicated by "FIRST SIDE" or "1ST". The second side is indicated by "SECOND SIDE" or "2ND". The upward is indicated by "UP". The downward is indicated by "DOWN".

The front-rear direction X is an example of a first direction of the present invention. The width direction Y is an example of a second direction of the present invention.

The slider portion 3 is disposed rearward of the indexer portion 2. The slider portion 3 is disposed frontward of the bridge portion 4. The slider portion 3 is disposed between the indexer portion 2 and the bridge portion 4. The slider portion 3 extends in the front-rear direction X.

The substrate processing apparatus 1 includes a first front portion 5 and a first rear portion 6. The first front portion 5, the bridge portion 4, and the first rear portion 6 are arranged in this order in the front-rear direction X. The first front portion 5 is disposed frontward of the bridge portion 4. The first rear portion 6 is disposed rearward of the bridge portion 4. The first rear portion 6 is disposed at a height position same as a height position of the first front portion 5. The bridge portion 4 is disposed between the first front portion 5 and the first rear portion 6.

More specifically, the indexer portion 2, the first front portion 5, the bridge portion 4, and the first rear portion 6 are arranged in this order in the front-rear direction X. The first front portion 5 is disposed rearward of the indexer portion 2.

The indexer portion 2, the slider portion 3, the bridge portion 4, and the first rear portion 6 are arranged in this order in the front-rear direction X. The slider portion 3 does not reach the first rear portion 6.

The substrate processing apparatus 1 includes a second front portion 7 and a second rear portion 8. The second front portion 7, the bridge portion 4, and the second rear portion 8 are arranged in this order in the front-rear direction X. The second front portion 7 is disposed frontward of the bridge portion 4. The second rear portion 8 is disposed rearward of the bridge portion 4. The second rear portion 8 is disposed at a height position same as a height position of the second front portion 7. The bridge portion 4 is disposed between the second front portion 7 and the second rear portion 8.

More specifically, the indexer portion 2, the second front portion 7, the bridge portion 4, and the second rear portion 8 are arranged in this order in the front-rear direction X. The second front portion 7 is disposed rearward of the indexer portion 2.

The indexer portion 2, the slider portion 3, the bridge portion 4, and the second rear portion 8 are arranged in this order in the front-rear direction X. The slider portion 3 does not reach the second rear portion 8.

The first front portion 5, the slider portion 3, and the second front portion 7 are arranged in this order in the vertical direction Z. The first front portion 5 is disposed downward of the slider portion 3. The second front portion 7 is disposed upward of the first front portion 5. The second front portion 7 is disposed upward of the slider portion 3. The slider portion 3 is disposed between the first front portion 5 and the second front portion 7.

The first front portion 5 is one layer. The second front portion 7 is another layer.

The first rear portion 6 and the second rear portion 8 are arranged in the vertical direction Z. The second rear portion 8 is disposed upward of the first rear portion 6.

The first rear portion 6 is one layer. The second rear portion 8 is another layer.

The slider portion 3 is connected to the indexer portion 2. The slider portion 3 is connected to the bridge portion 4.

The slider portion 3 transports the substrate W between the indexer portion 2 and the bridge portion 4. For example, the slider portion 3 transports the substrate W from the indexer portion 2 to the bridge portion 4. The slider portion 3 transports the substrate W from the bridge portion 4 to the indexer portion 2.

The bridge portion 4 is connected to the slider portion 3. The bridge portion 4 is connected to the first front portion 5, the first rear portion 6, the second front portion 7, and the second rear portion 8. The bridge portion 4 transports the substrate W between the slider portion 3, the first front portion 5, the first rear portion 6, the second front portion 7, and the second rear portion 8.

The bridge portion 4 transports the substrate W between the slider portion 3 and the first front portion 5. For example, the bridge portion 4 transports the substrate W from the slider portion 3 to the first front portion 5. The bridge portion 4 transports the substrate W from the first front portion 5 to the slider portion 3.

Similarly, the bridge portion 4 transports the substrate W between the slider portion 3 and the first rear portion 6. For example, the bridge portion 4 transports the substrate W from the slider portion 3 to the first rear portion 6. The bridge portion 4 transports the substrate W from the first rear portion 6 to the slider portion 3.

The bridge portion 4 transports the substrate W between the slider portion 3 and the second front portion 7. For example, the bridge portion 4 transports the substrate W from the slider portion 3 to the second front portion 7. The bridge portion 4 transports the substrate W from the second front portion 7 to the slider portion 3.

The bridge portion 4 transports the substrate W between the slider portion 3 and the second rear portion 8. For example, the bridge portion 4 transports the substrate W from the slider portion 3 to the second rear portion 8. The bridge portion 4 transports the substrate W from the second rear portion 8 to the slider portion 3.

The bridge portion 4 performs "take-in", "distribution", "collection", and "discharge".

"Take-in" means taking the substrate W in the slider portion 3 and transporting the substrate W from the slider portion 3 to the bridge portion 4.

"Distribution" means transporting the substrate W from the bridge portion 4 to the first front portion 5, the first rear portion 6, the second front portion 7, and the second rear portion 8, and placing the substrate W in the first front portion 5, the first rear portion 6, the second front portion 7, and the second rear portion 8.

"Collection" means taking the substrate W in the first front portion 5, the first rear portion 6, the second front portion 7, and the second rear portion 8, and transporting the substrate W to the bridge portion 4 from the first front portion 5, the first rear portion 6, the second front portion 7, and the second rear portion 8.

"Discharge" means transporting the substrate W from the bridge portion 4 to the slider portion 3 and placing the substrate W in the slider portion 3.

The indexer portion 2 and the first front portion 5 are configured not to directly deliver the substrate W to each other. The slider portion 3 and the first front portion 5 are configured not to directly deliver the substrate W to each other. When the substrate W is transported from the indexer portion 2 to the first front portion 5, the substrate W always passes through the slider portion 3 and the bridge portion 4. When the substrate W is transported from the first front portion 5 to the indexer portion 2, the substrate W always passes through the slider portion 3 and the bridge portion 4.

The indexer portion 2 and the first rear portion 6 are configured not to directly deliver the substrate W to each other. The slider portion 3 and the first rear portion 6 are configured not to directly deliver the substrate W to each other. When the substrate W is transported from the indexer portion 2 to the first rear portion 6, the substrate W always passes through the slider portion 3 and the bridge portion 4. When the substrate W is transported from the first rear portion 6 to the indexer portion 2, the substrate W always passes through the slider portion 3 and the bridge portion 4.

The indexer portion 2 and the second front portion 7 are configured not to directly deliver the substrate W to each other. The slider portion 3 and the second front portion 7 are configured not to directly deliver the substrate W to each other. When the substrate W is transported from the indexer portion 2 to the second front portion 7, the substrate W always passes through the slider portion 3 and the bridge portion 4. When the substrate W is transported from the second front portion 7 to the indexer portion 2, the substrate W always passes through the slider portion 3 and the bridge portion 4.

The indexer portion 2 and the second rear portion 8 are configured not to directly deliver the substrate W to each other. The slider portion 3 and the second rear portion 8 are configured not to directly deliver the substrate W to each other. When the substrate W is transported from the indexer portion 2 to the second rear portion 8, the substrate W always passes through the slider portion 3 and the bridge portion 4. When the substrate W is transported from the second rear portion 8 to the indexer portion 2, the substrate W always passes through the slider portion 3 and the bridge portion 4.

The first front portion 5 processes the substrate W. The first rear portion 6 processes the substrate W. The second front portion 7 processes the substrate W. The second rear portion 8 processes the substrate W.

The processing performed on the substrate W in the first front portion 5 includes "liquid processing". The processing performed on the substrate W in the first front portion 5 further includes "non-liquid processing". Similarly, the processing performed on the substrate W in the first rear portion 6 includes "liquid processing". The processing performed on the substrate W in the first rear portion 6 further includes "non-liquid processing". The processing performed on the substrate W in the second front portion 7 includes "liquid processing". The processing performed on the substrate W in the second front portion 7 further includes "non-liquid processing". The processing performed on the substrate W in the second rear portion 8 includes "liquid processing". The processing performed on the substrate W in the second rear portion 8 further includes "non-liquid processing".

The "liquid processing" is processing performed on the substrate W by supplying a processing liquid to the substrate W. The "liquid processing" includes, for example, at least one of coating processing, development processing, etching processing, or cleaning processing. The "processing liquid" includes, for example, at least one of a coating film material, a developer, an etching solution, or a cleaning liquid.

The "non-liquid processing" is processing or inspection performed on the substrate W without supplying the processing liquid to the substrate W. The "non-liquid processing" includes, for example, at least one of heat processing or inspection.

The processing performed on the substrate W in the first rear portion 6 is identical to the processing performed on the substrate W in the first front portion 5. The processing performed on the substrate W in the second rear portion 8 is identical to the processing performed on the substrate W in the second front portion 7.

The processing performed on the substrate W in the second front portion 7 is identical to the processing performed on the substrate W in the first front portion 5. The processing performed on the substrate W in the second rear portion 8 is identical to the processing performed on the substrate W in the first front portion 5.

The first front portion 5 includes a plurality of processing units 50 and one transport mechanism 55. The transport mechanism 55 transports the substrate W to the plurality of processing units 50. The plurality of processing units 50 process a plurality of substrates W in parallel. Similarly, the first rear portion 6 includes a plurality of processing units 60 and one transport mechanism 65. The second front portion 7 includes a plurality of processing units 70 and one transport mechanism 75. The second rear portion 8 includes a plurality of processing units 80 and one transport mechanism 85.

The transport mechanism 55 is an example of a first front transport mechanism of the present invention. The transport mechanism 65 is an example of a first rear transport mechanism of the present invention. The transport mechanism 75 is an example of a second front transport mechanism of the present invention. The transport mechanism 85 is an example of a second rear transport mechanism of the present invention.

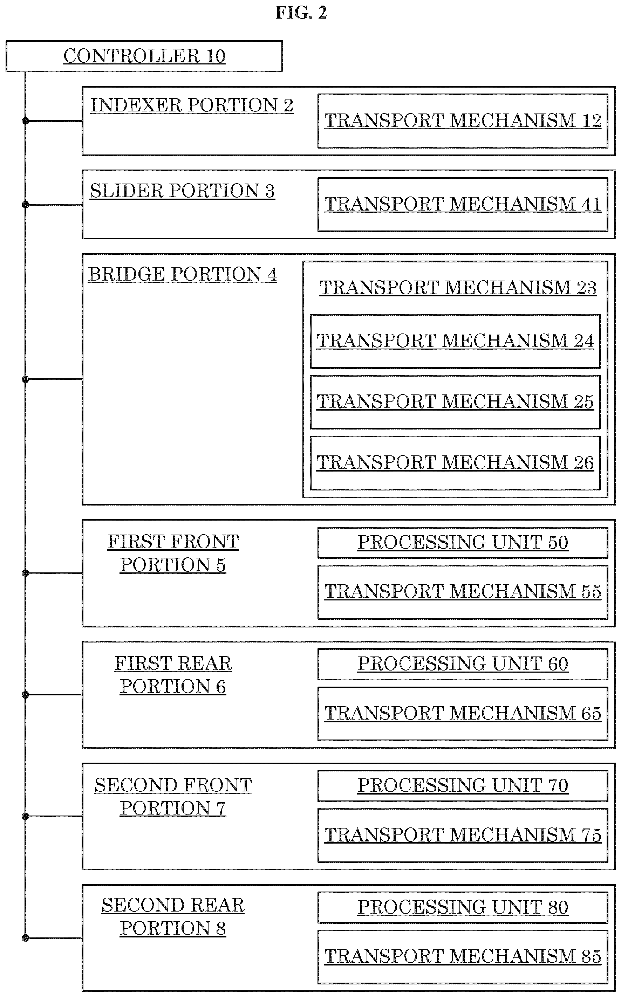

FIG. 2 is a control block diagram of the substrate processing apparatus 1. The substrate processing apparatus 1 includes a controller 10. The controller 10 controls the indexer portion 2, the slider portion 3, the bridge portion 4, the first front portion 5, the first rear portion 6, the second front portion 7, and the second rear portion 8. Specifically, the controller 10 controls the processing units 50, 60, 70, and 80 and the transport mechanisms 55, 65, 75, and 85.

The controller 10 is implemented by, for example, a central processing unit (CPU), a random access memory (RAM), and a storage medium. The central processing unit executes arithmetic processing. The random access memory functions as a work area for arithmetic processing. The storage medium is, for example, a fixed disk. The controller 10 has various types of information stored in advance in the storage medium. The information included in the controller 10 includes, for example, transport information and processing information. The transport information defines a procedure of transporting the substrate W. The processing information defines a procedure of processing the substrate W. The processing information is also referred to as a processing recipe.

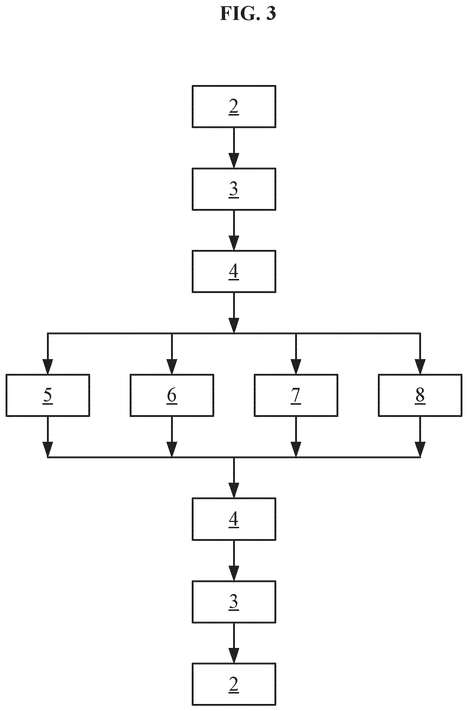

FIG. 3 is a view schematically illustrating a transport path of the substrate W. An operation example of the substrate processing apparatus 1 will be described. A substrate processing method will be described.

The substrates W are transported from the indexer portion 2 to the slider portion 3. The substrates W are transported from the slider portion 3 to the bridge portion 4. The substrates W are distributed from the bridge portion 4 to the first front portion 5, the first rear portion 6, the second front portion 7, and the second rear portion 8. The substrates W are processed in parallel in the first front portion 5, the first rear portion 6, the second front portion 7, and the second rear portion 8. The substrates W are collected to the bridge portion 4 from the first front portion 5, the first rear portion 6, the second front portion 7, and the second rear portion 8. The substrates W are transported from the bridge portion 4 to the slider portion 3. The substrates W are transported from the slider portion 3 to the indexer portion 2.

Reference is made to FIG. 1. An operation example of the substrate processing apparatus 1 will be described. A substrate processing method will be described. For convenience, a plurality of substrates W are referred to as substrates Wa, Wb, Wc, and Wd in order to distinguish from one another.

The slider portion 3 transports the substrates Wa, Wb, Wc, and Wd from the indexer portion 2 to the bridge portion 4.

The bridge portion 4 performs take-in and distribution. Thus, the bridge portion 4 transports the substrate Wa from the slider portion 3 to the first front portion 5. Similarly, the bridge portion 4 transports the substrate Wb from the slider portion 3 to the first rear portion 6. The bridge portion 4 transports the substrate Wc from the slider portion 3 to the second front portion 7. The bridge portion 4 transports the substrate Wd from the slider portion 3 to the second rear portion 8.

The first front portion 5 processes the substrate Wa. The first rear portion 6 processes the substrate Wb. The second front portion 7 processes the substrate Wc. The second rear portion 8 processes the substrate Wd.

The bridge portion 4 performs collection and discharge. Thus, the bridge portion 4 transports the substrate Wa from the first front portion 5 to the slider portion 3. Similarly, the bridge portion 4 transports the substrate Wb from the first rear portion 6 to the slider portion 3. The bridge portion 4 transports the substrate Wc from the second front portion 7 to the slider portion 3. The bridge portion 4 transports the substrate Wd from the second rear portion 8 to the slider portion 3.

The slider portion 3 transports the substrates Wa, Wb, Wc, and Wd from the bridge portion 4 to the indexer portion 2.

### <2. Indexer portion 2>

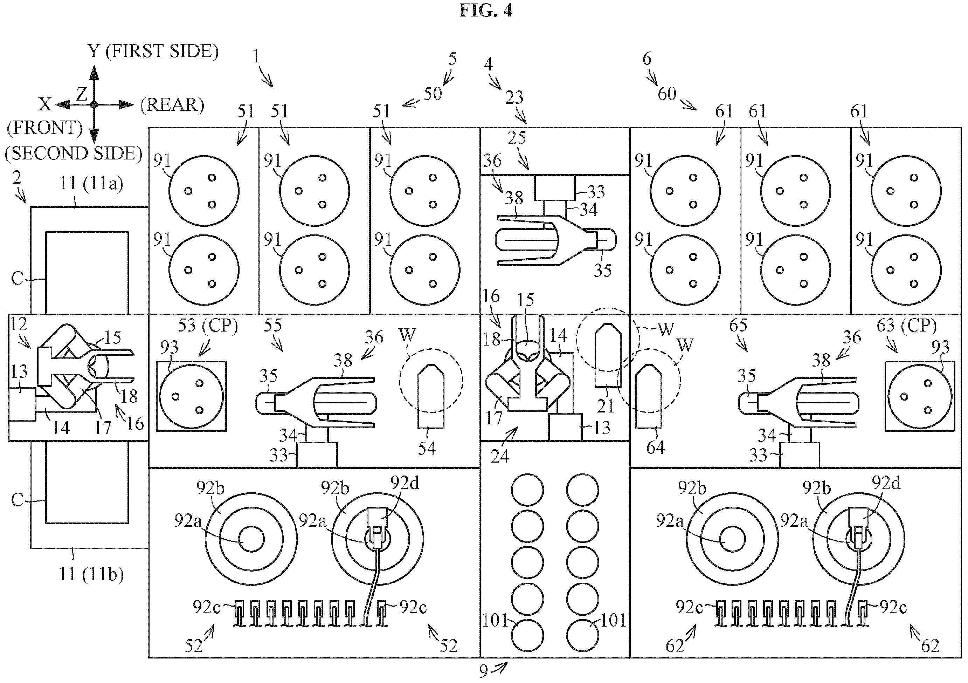

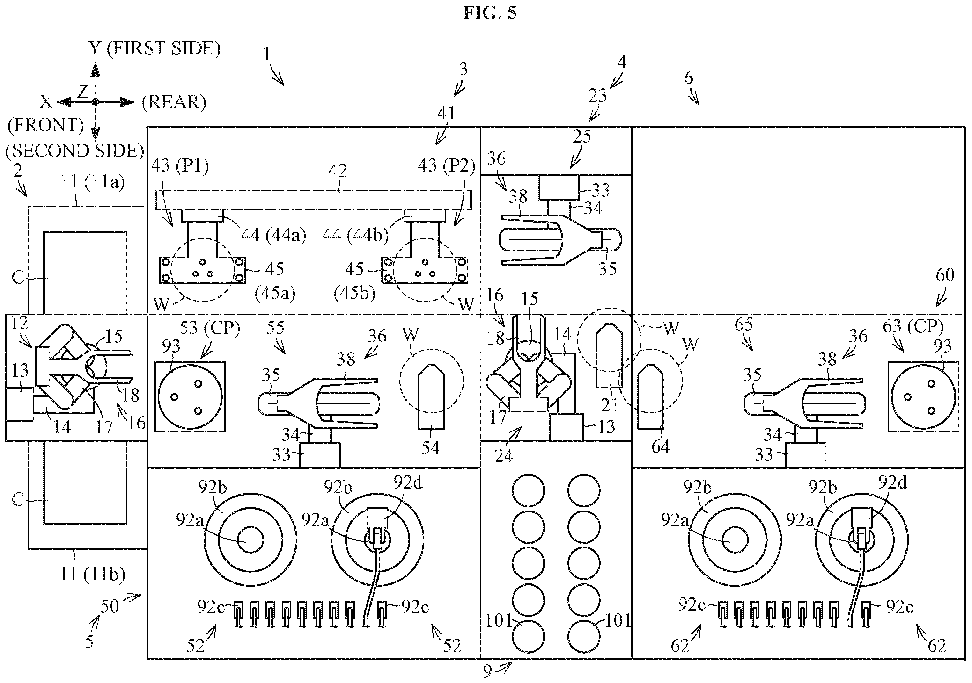

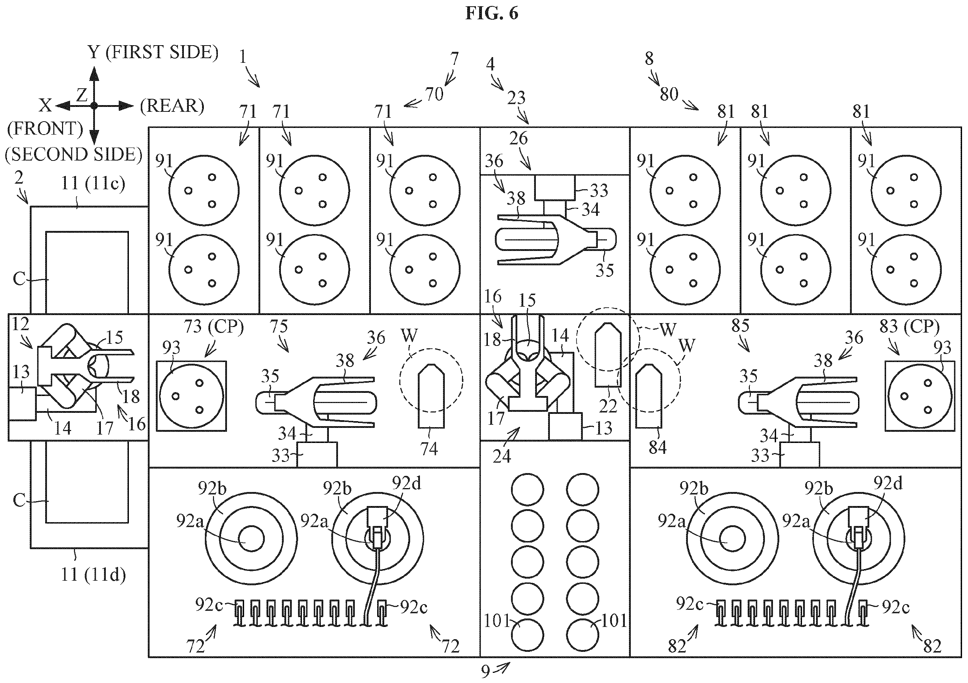

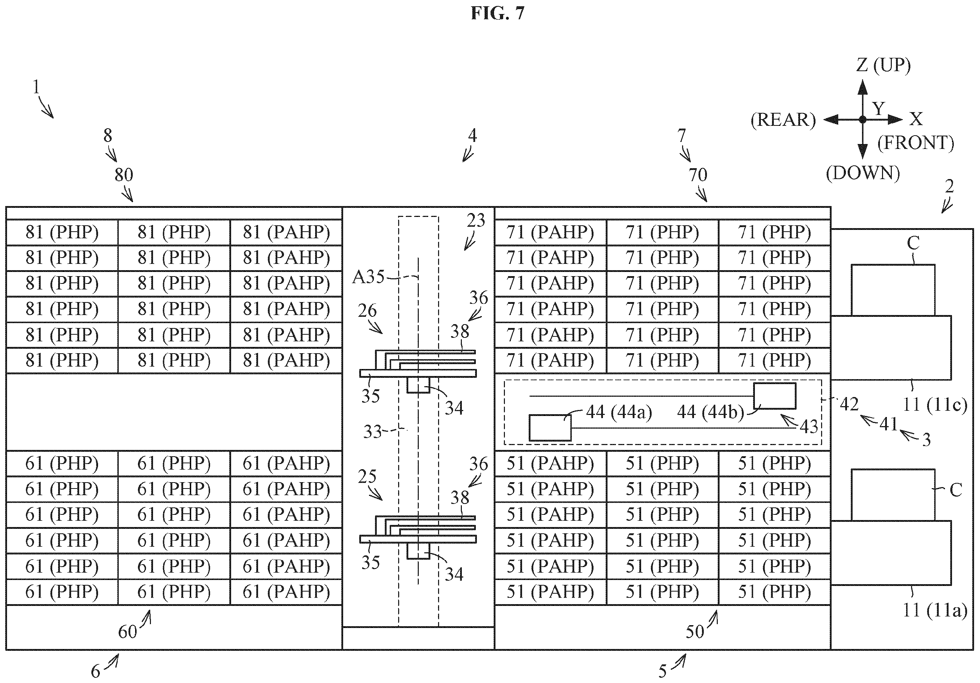

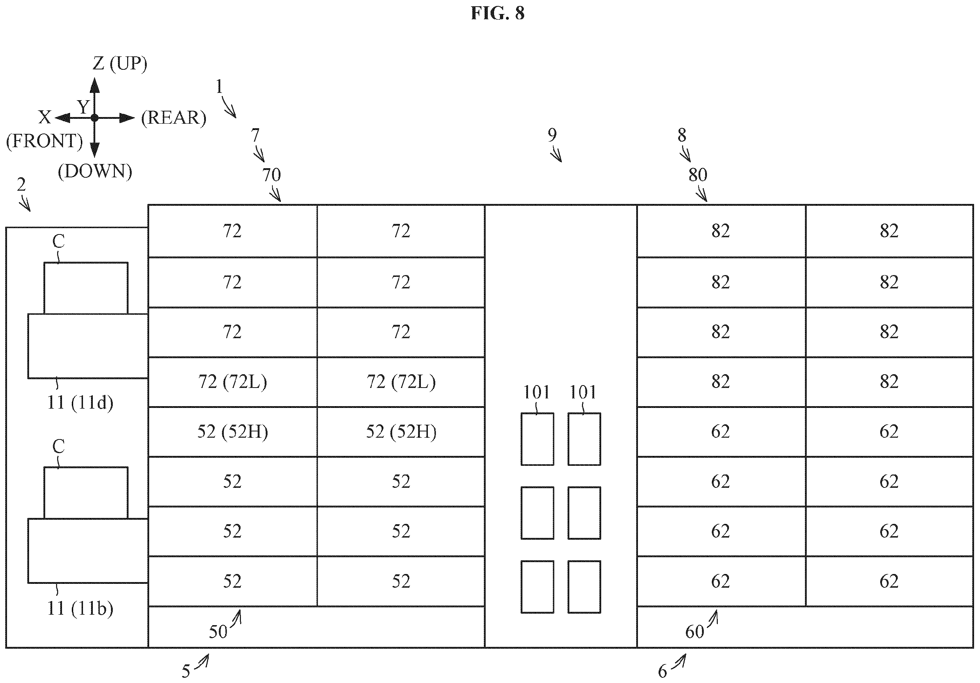

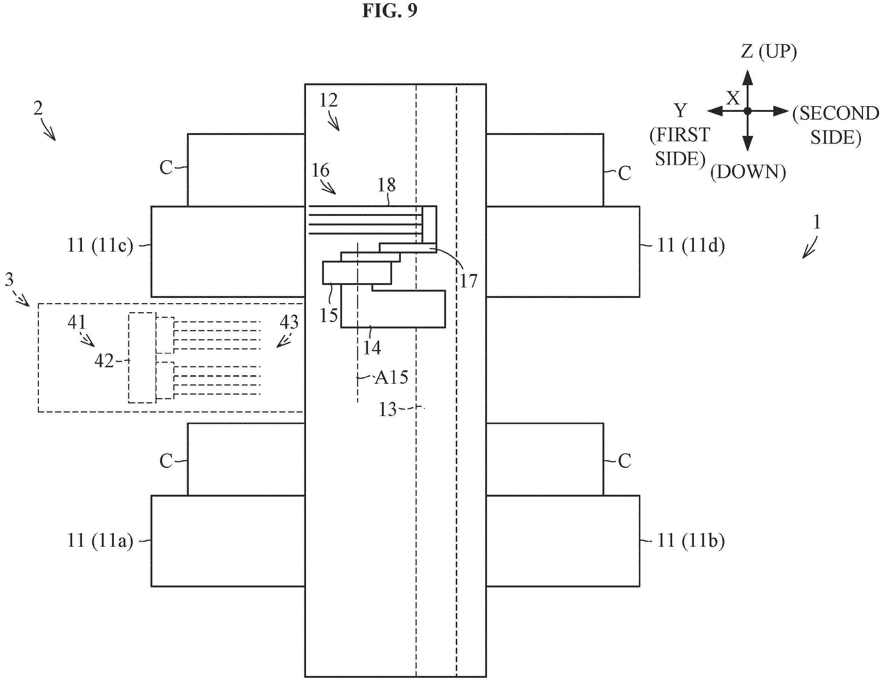

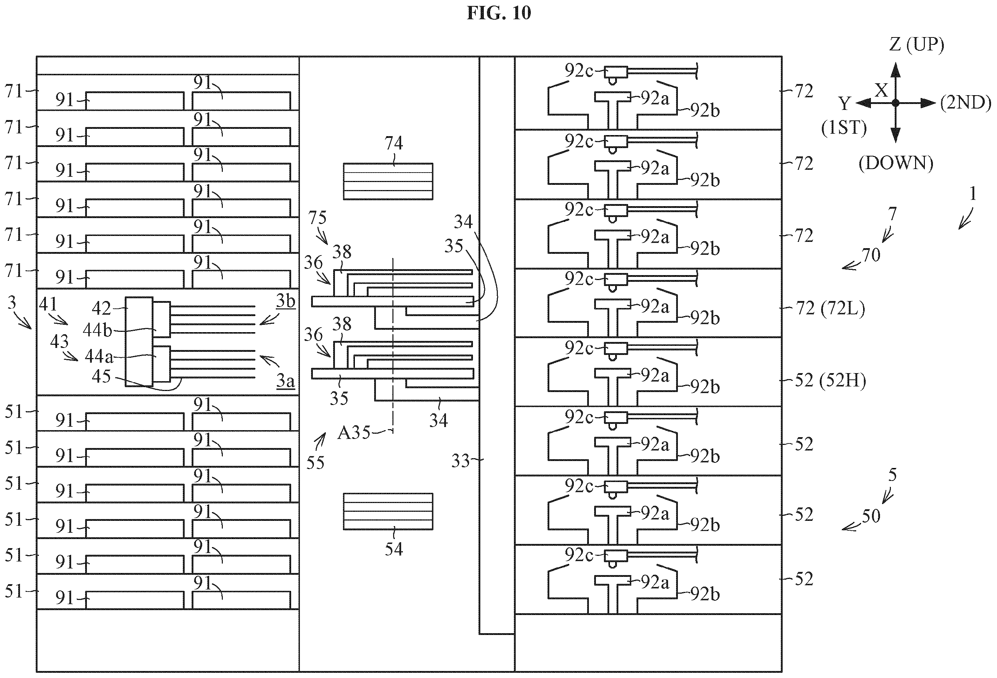

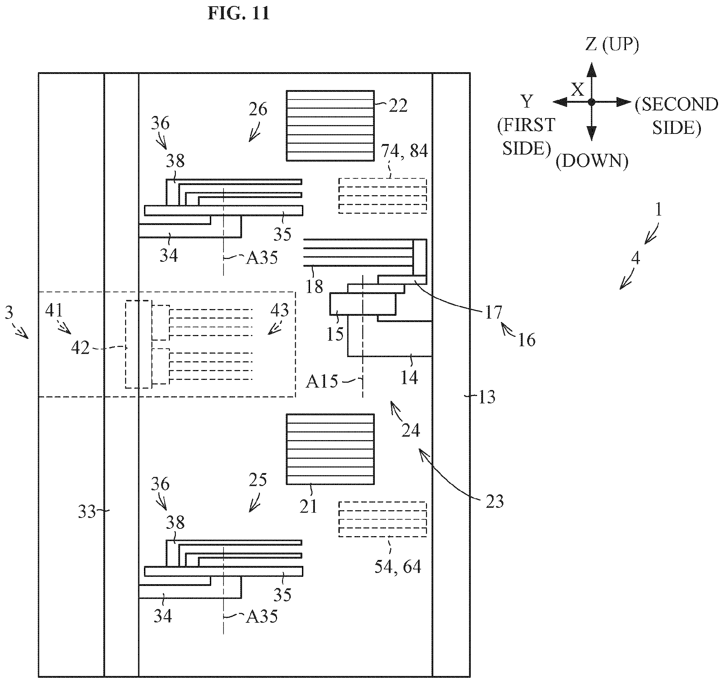

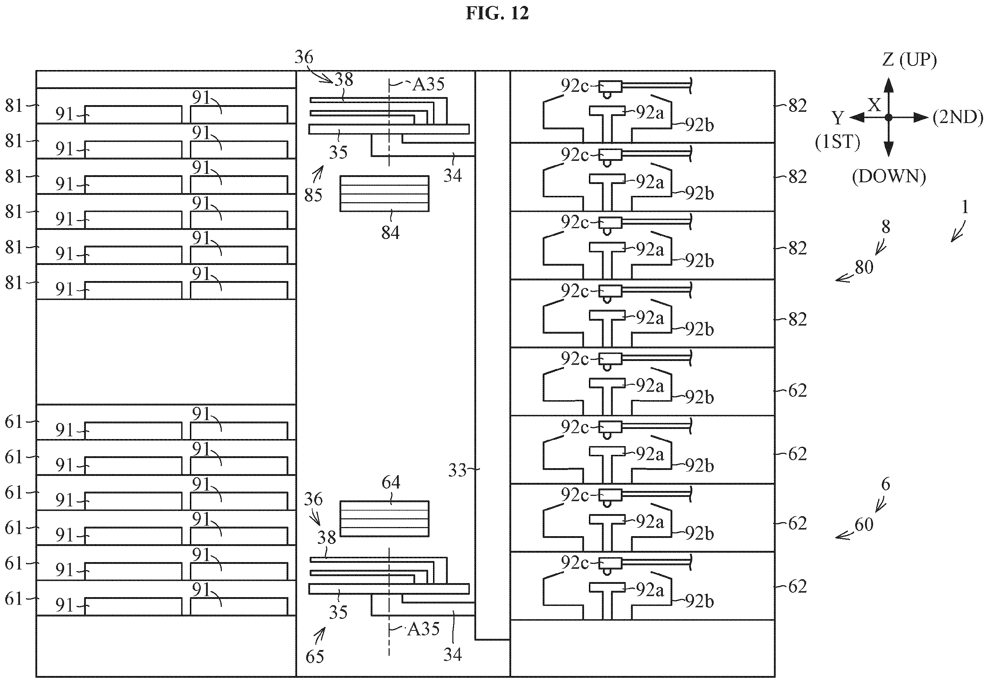

FIGS. 4, 5, and 6 each are plan views of the substrate processing apparatus 1. FIG. 4 illustrates the first front portion 5 and the first rear portion 6. FIG. 5 illustrates the slider portion 3, the first front portion 5, and the first rear portion 6. FIG. 6 illustrates the second front portion 7 and the second rear portion 8. FIG. 7 is a first side view of the substrate processing apparatus 1. FIG. 8 is a second side view of the substrate processing apparatus 1. FIG. 9 is a front view of the indexer portion 2. FIG. 10 is a front view of the slider portion 3, the first front portion 5, and the second front portion 7. FIG. 11 is a front view of the bridge portion 4. FIG. 12 is a front view of the first rear portion 6 and the second rear portion 8.

The indexer portion 2 includes a plurality of (for example, four) carrier stages 11. One carrier C is placed on each carrier stage 11.

The carrier C accommodates a plurality of substrates W. The carrier C is, for example, a front opening unified pod (FOUP), a standard mechanical interface (SMIF), or an open cassette (OC). The carrier C is transported to the substrate processing apparatus 1 by a carrier transport mechanism (not illustrated).

The indexer portion 2 includes a transport mechanism 12. The transport mechanism 12 transports the substrate W to the carrier C. The transport mechanism 12 transports the substrate W between the carrier C and the slider portion 3.

The transport mechanism 12 is, for example, a transport robot.

The transport mechanism 12 includes a support column 13, a lift portion 14, a rotation portion 15, and a support portion 16. In FIG. 9, the support column 13 is indicated by a broken line for convenience. The support column 13 is fixedly installed. The support column 13 extends in the vertical direction Z. The lift portion 14 is supported by the support column 13. The lift portion 14 moves in the vertical direction Z with respect to the support column 13. The rotation portion 15 is supported by the lift portion 14. The rotation portion 15 rotates about a rotation axis A15 with respect to the lift portion 14. The rotation axis A15 is illustrated in FIG. 9. The rotation axis A15 extends in the vertical direction Z. The rotation axis A15 passes through the rotation portion 15, for example. The support portion 16 is supported by the rotation portion 15. The support portion 16 moves forward and backward with respect to the rotation portion 15. More specifically, the support portion 16 reciprocates in one direction determined by an orientation of the rotation portion 15. "One direction determined by an orientation of the rotation portion 15" is a radial direction of the rotation axis A15. The radial direction of the rotation axis A15 is horizontal. The support portion 16 supports the substrate W.

The support portion 16 supports a plurality of substrates W at a time. The transport mechanism 12 transports a plurality of substrates W at a time.

The support portion 16 includes an articulated arm 17 and a plurality of hands 18. The articulated arm 17 is directly supported by the rotation portion 15. The hand 18 is directly supported by the articulated arm 17. The articulated arm 17 bends and extends. As a result, the hand 18 moves forward and backward with respect to the rotation portion 15. Each of the hands 18 supports one substrate W.

Each of the hands 18 supports the substrate W in a horizontal posture. Each of the hands 18 is in contact with a back surface of the substrate W. Each of the hands 18 is in contact with a peripheral portion of the back surface of the substrate W. Each of the hands 18 has a Y-shape in plan view.

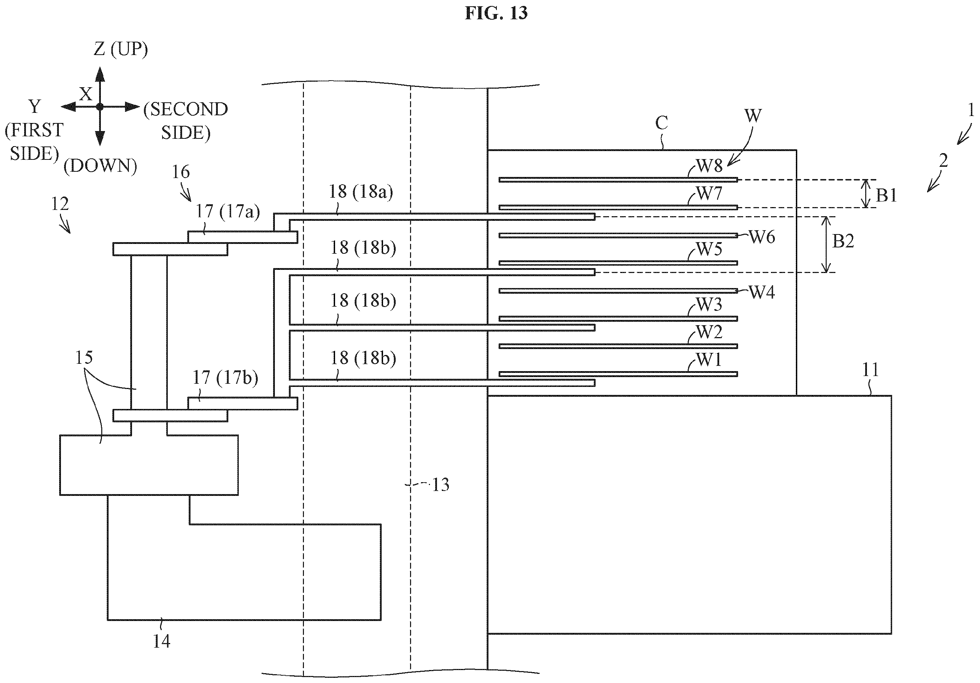

FIG. 13 is a detailed front view of the indexer portion 2. The carrier C supports the substrate W in a horizontal posture. In the carrier C, a plurality of substrates W are arranged in the vertical direction Z. A distance between two substrates W adjacent to each other in the vertical direction Z in the carrier C is referred to as a pitch B1. The pitch B1 is, for example, 10 mm.

The plurality of hands 18 are arranged in the vertical direction Z. A distance between two hands 18 adjacent to each other in the vertical direction Z is referred to as a pitch B2. The pitch B2 is twice the pitch B1. The pitch B2 is, for example, 20mm.

The substrates W in the carrier C are referred to as substrates W1, W2, W3, W4, W5, W6, W7, and W8. The substrates W1, W2, W3, W4, W5, W6, W7, and W8 are arranged in this order in the vertical direction Z. The transport mechanism 12 takes the substrates W1, W3, W5, and W7 in the carrier C on the carrier stage 11 at a time. The transport mechanism 12 places the substrates W1, W3, W5, and W7 into the carrier C on the carrier stage 11 at a time. Similarly, the transport mechanism 12 transports the substrates W2, W4, W6, and W8 to the carrier C on the carrier stage 11 at a time.

At least one of the hands 18 may move relative to the rotation portion 15 independently of other hands 18. In this case, it is also easy for the transport mechanism 12 to transport one substrate W at a time.

For example, the articulated arm 17 includes articulated arms 17a and 17b. The articulated arm 17b operates independently of the articulated arm 17a. Each of the articulated arms 17a and 17b is directly supported by the rotation portion 15. The articulated arm 17a supports one hand 18. The articulated arm 17b supports other three hands 18.

For convenience, one hand 18 supported by the articulated arm 17a is referred to as a "hand 18a". The hands 18 supported by the articulated arm 17b are referred to as a "hands 18b". The articulated arm 17a moves the hand 18a forward and backward with respect to the rotation portion 15. The articulated arm 17b moves the hands 18b forward and backward with respect to the rotation portion 15. The hands 18b move independently of the hand 18a.

For example, when the transport mechanism 12 transports one substrate W, the articulated arm 17a alone moves the hand 18a, and the articulated arm 17b does not move the hands 18b. When the transport mechanism 12 transports one substrate W, the hand 18a alone supports the substrate W, and the hands 18b do not support the substrate W.

For example, when the transport mechanism 12 transports a plurality of substrates W, the articulated arms 17a and 17b may move the hands 18a and 18b in synchronization. When the transport mechanism 12 transports a plurality of substrates W, the hands 18a and 18b each may simultaneously support the substrates W.

The transport mechanism 12 is an example of a first transport mechanism of the present invention. The support portion 16 of the transport mechanism 12 is an example of a first support portion of the present invention. The hand 18 of the transport mechanism 12 is an example of a first hand of the present invention.

### <3. Bridge portion 4>

Reference is made to FIGS. 4 to 12. The bridge portion 4 will be described.

The bridge portion 4 includes a placing portion 21. A plurality of (for example, eight) substrates W are placed on the placing portion 21 at a time. The placing portion 21 supports the substrate W in a horizontal posture. The plurality of substrates W on the placing portion 21 are arranged in the vertical direction Z. Although not illustrated, the placing portion 21 includes, for example, at least one of a horizontal plate, a support pin, or a shelf.

The bridge portion 4 includes a placing portion 22. The placing portion 22 has the same structure as the placing portion 21.

The placing portion 21 is an example of a first intermediate placing portion of the present invention. The placing portion 22 is an example of a second intermediate placing portion of the present invention.

The bridge portion 4 includes a transport mechanism 23. The transport mechanism 23 performs the above-described "take-in", "distribution", "collection", and "discharge".

The transport mechanism 23 is, for example, a transport robot.

For example, the transport mechanism 23 includes a plurality of transport mechanisms. The transport mechanism 23 includes transport mechanisms 24, 25, and 26. The transport mechanism 24 performs "take-in", "collection", and "discharge". Each of the transport mechanisms 25 and 26 performs a part of "distribution". The transport mechanism 25 performs distribution related to the first front portion 5 and the first rear portion 6. The transport mechanism 26 performs distribution related to the second front portion 7 and the second rear portion 8.

The transport mechanism 24 is, for example, a transport robot. The transport mechanism 25 is, for example, a transport robot. The transport mechanism 26 is, for example, a transport robot.

The transport mechanism 24 and the transport mechanism 25 deliver the substrate W to each other via the placing portion 21. The transport mechanism 24 and the transport mechanism 26 deliver the substrate W to each other via the placing portion 22. For example, the transport mechanism 24 distributes the substrate W to the placing portions 21 and 22. The transport mechanism 24 distributes the substrate W to the transport mechanisms 25 and 26 via the placing portions 21 and 22.

A structure of the transport mechanism 24 will be described. The transport mechanism 24 has the same structure as the transport mechanism 12 of the indexer portion 2. In the present specification, in a case where different elements have a common structure, the structure is denoted by a common reference sign, and a detailed description thereof is omitted. For example, the transport mechanism 24 includes a support column 13, a lift portion 14, a rotation portion 15, and a support portion 16. The support portion 16 includes an articulated arm 17 and a plurality of hands 18.

A structure of the transport mechanism 25 will be described. The transport mechanism 25 includes a support column 33, a lift portion 34, a rotation portion 35, and a support portion 36. The support column 33 is fixedly installed. The support column 33 extends in the vertical direction Z. The lift portion 34 is supported by the support column 33. The lift portion 34 moves in the vertical direction Z with respect to the support column 33. The rotation portion 35 is supported by the lift portion 34. The rotation portion 35 rotates about a rotation axis A35 with respect to the lift portion 34. The rotation axis A35 is illustrated in FIG. 11. The rotation axis A35 extends in the vertical direction Z. The rotation axis A35 passes through the rotation portion 35, for example. The support portion 36 is supported by the rotation portion 35. The support portion 36 moves forward and backward with respect to the rotation portion 35. More specifically, the support portion 36 reciprocates in one direction determined by an orientation of the rotation portion 35. "One direction determined by an orientation of the rotation portion 35" is a radial direction of the rotation axis A35. The radial direction of the rotation axis A35 is horizontal. The support portion 36 supports the substrate W.

The support portion 36 supports a plurality of substrates W at a time. The transport mechanism 25 transports a plurality of substrates W at a time.

The support portion 36 includes a plurality of (for example, two) hands 38. Each hand 38 is directly supported by the rotation portion 35. Each hand 38 slides with respect to the rotation portion 35. Each of the hands 38 supports one substrate W.

Each of the hands 38 supports the substrate W in a horizontal posture. Each of the hands 38 is in contact with a back surface of the substrate W. Each of the hands 38 is in contact with a peripheral portion of the back surface of the substrate W. Each of the hands 38 has a Y-shape in plan view.

The plurality of hands 38 are arranged in the vertical direction Z.

The plurality of hands 38 may move with respect to the rotation portion 35 independently of one another.

A structure of the transport mechanism 26 will be described. The transport mechanism 26 has the same structure as the transport mechanism 25. For example, the transport mechanism 26 includes a support column 33, a lift portion 34, a rotation portion 35, and a support portion 36. The support portion 36 includes a plurality of hands 38.

The transport mechanism 23 is an example of a third transport mechanism of the present invention.

The transport mechanism 24 is an example of a first collection mechanism of the present invention. The transport mechanism 25 is an example of a first distribution mechanism of the present invention. The transport mechanism 26 is an example of a second distribution mechanism of the present invention.

The support portion 16 of the transport mechanism 24 is an example of a third support portion of the present invention. The support portion 36 of the transport mechanism 25 is an example of the third support portion of the present invention. The support portion 36 of the transport mechanism 26 is an example of the third support portion of the present invention.

The hand 18 of the transport mechanism 24 is an example of a third hand of the present invention. The hand 38 of the transport mechanism 25 is an example of the third hand of the present invention. The hand 38 of the transport mechanism 26 is an example of the third hand of the present invention.

The support portion 16 of the transport mechanism 24, the support portion 36 of the transport mechanism 25, and the support portion 36 of the transport mechanism 26 are referred to as "support portions of the transport mechanism 23" when not distinguished from one another. The hand 18 of the transport mechanism 24, the hand 38 of the transport mechanism 25, and the hand 38 of the transport mechanism 26 are referred to as "hands of the support portion of the transport mechanism 23" or "hands of the transport mechanism 23" when not distinguished from one another.

### <4. Slider portion 3>

Reference is made to FIG. 5. The slider portion 3 includes a transport mechanism 41. The transport mechanism 41 transports the substrate W.

The transport mechanism 41 is, for example, a transport robot.

The transport mechanism 41 includes a guide 42 and a support portion 43. The guide 42 is fixedly installed. The guide 42 extends linearly. The guide 42 extends in the front-rear direction X. The support portion 43 is attached to the guide 42. The support portion 43 is guided by the guide 42. The support portion 43 slides with respect to the guide 42. The support portion 43 moves parallel to the guide 42. The support portion 43 linearly moves along the guide 42. The support portion 43 moves in the front-rear direction X along the guide 42. The support portion 43 reciprocates along the guide 42. The support portion 43 supports the substrate W.

The transport mechanism 41 does not reach the indexer portion 2. The guide 42 does not reach the indexer portion 2. The transport mechanism 41 does not enter the indexer portion 2. The support portion 43 does not enter the indexer portion 2.

The transport mechanism 41 does not reach the bridge portion 4. The guide 42 does not reach the bridge portion 4. The transport mechanism 41 does not enter the bridge portion 4. The support portion 43 does not enter the bridge portion 4.

The support portion 43 does not move in the width direction Y with respect to the guide 42. For example, the support portion 43 does not extend or contract with respect to the guide 42.

The support portion 43 supports a plurality of substrates W at a time. The transport mechanism 41 transports a plurality of substrates W at a time.

The support portion 43 includes a movable element 44 and a plurality of (for example, eight) hands 45. The movable element 44 is directly supported by the guide 42. The hand 45 is directly supported by the movable element 44. The movable element 44 slides with respect to the guide 42. As a result, the hand 45 moves with respect to the guide 42. Each of the hands 45 supports one substrate W.

Each of the hands 45 supports the substrate W in a horizontal posture. Each of the hands 45 is in contact with a back surface of the substrate W. Each of the hands 45 is in contact with a central portion of the back surface of the substrate W. Each of the hands 45 has a T-shape in plan view.

The plurality of hands 45 are arranged in the vertical direction Z.

Some of the hands 45 may move relative to the guide 42 independently of other hands 45. In this case, it is easy for the transport mechanism 41 to efficiently transport a large number of substrates W.

For example, the movable element 44 includes movable elements 44a and 44b. The movable element 44b operates independently of the movable element 44a. Each of the movable elements 44a and 44b is directly supported by the guide 42. Each of the movable elements 44a and 44b supports a plurality of (four) hands 45.

For convenience, the hand 45 supported by the movable element 44a is referred to as a "hand 45a". The hand 45 supported by the movable element 44b is referred to as a "hand 45b". The movable element 44a moves the hand 45a with respect to the guide 42. The movable element 44b moves the hand 45b with respect to the guide 42. The hand 45b moves independently of the hand 45a.

For example, each of the hands 45a and 45b may transport the substrate W in one direction alone. The hand 45a transports the substrate W from the indexer portion 2 to the bridge portion 4, and does not transport the substrate W from the bridge portion 4 to the indexer portion 2. The hand 45b transports the substrate W from the bridge portion 4 to the indexer portion 2, and does not transport the substrate W from the indexer portion 2 to the bridge portion 4.

Alternatively, each of the hands 45a and 45b may transport the substrate W in both directions. The hand 45a transports the substrate W from the indexer portion 2 to the bridge portion 4, and transports the substrate W from the bridge portion 4 to the indexer portion 2. The hand 45b transports the substrate W from the indexer portion 2 to the bridge portion 4, and transports the substrate W from the bridge portion 4 to the indexer portion 2.

A structure of the transport mechanism 41 will be described. Although not illustrated, the transport mechanism 41 includes a drive mechanism. The drive mechanism moves the support portion 43 with respect to the guide 42.

The drive mechanism is provided to the guide 42, for example. The drive mechanism includes, for example, a driving pulley, a driven pulley, a belt, and a motor. The belt is wrapped around the driving pulley and the driven pulley. The belt extends along the guide 42. The support portion 43 is attached to the belt. For example, the movable element 44 is attached to the belt. The motor is connected to the driving pulley. The motor rotates the driving pulley in a forward direction and a reverse direction. When the driving pulley rotates, the belt rotates between the driving pulley and the driven pulley, and the support portion 43 reciprocates between the driving pulley and the driven pulley.

Alternatively, the drive mechanism may be provided to the support portion 43. The drive mechanism may include a ball screw mechanism. The drive mechanism may include an air cylinder.

The transport mechanism 41 is an example of a second transport mechanism of the present invention. The support portion 43 is an example of a second support portion of the present invention. The hand 45 is an example of a second hand of the present invention.

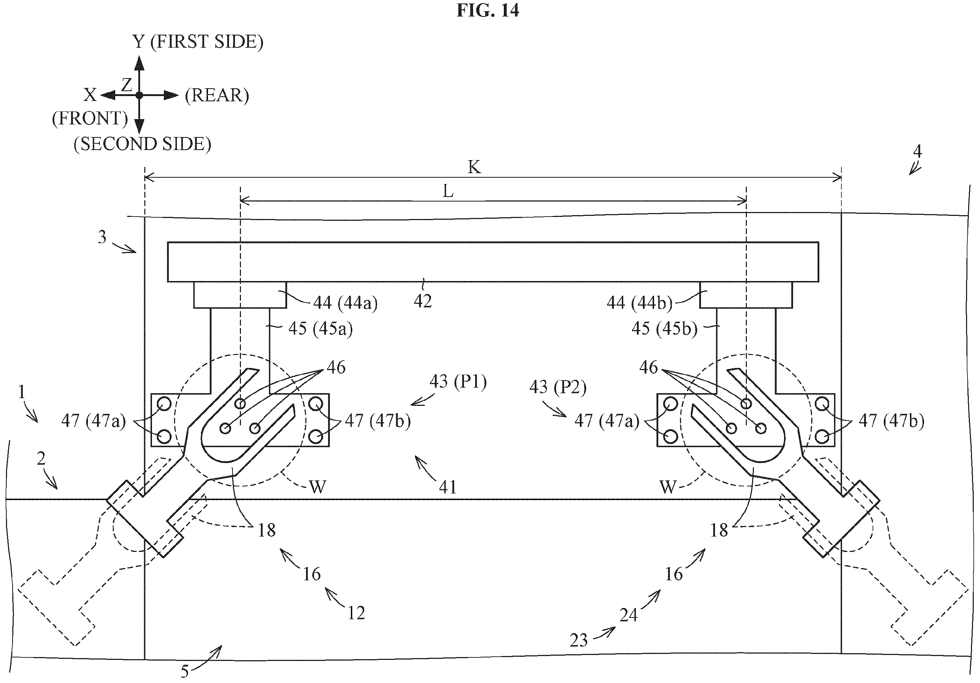

FIG. 14 is a detailed plan view of the slider portion 3. The hand 45 includes one or more (for example, three) contact portions 46. The contact portion 46 is in contact with a back surface of the substrate W. The contact portion 46 is in contact with a central portion of the back surface of the substrate W. The contact portion 46 has, for example, a pin shape or a pad shape.

The contact portion 46 may suction the back surface of the substrate W.

The hand 45 includes one or more (for example, four) guards 47. The guard 47 is disposed slightly outward of the substrate W. The guard 47 can come into contact with a peripheral edge of the substrate W. For example, when the substrate W is significantly shifted relative to the hand 45, the guard 47 comes into contact with the peripheral edge of the substrate W. The guard 47 inhibits falling of the substrate W from the hand 45.

The guard 47 is disposed outward of the contact portion 46.

The guard 47 includes a guard 47a and a guard 47b. The guard 47a, the contact portion 46, and the guard 47b are arranged in this order in the front-rear direction X. The guard 47a is disposed frontward of the contact portion 46. The guard 47b is disposed rearward of the contact portion 46. The contact portion 46 is disposed between the guard 47a and the guard 47b.

The transport mechanism 12 and the transport mechanism 41 deliver the substrate W to each other. The transport mechanism 12 and the transport mechanism 41 may deliver a plurality of substrates W to each other at a time.

When the transport mechanism 12 and the transport mechanism 41 deliver the substrate W to each other, a part of the transport mechanism 12 enters the slider portion 3. When the transport mechanism 12 and the transport mechanism 41 deliver the substrate W to each other, the support portion 16 of the transport mechanism 12 enters the slider portion 3.

When the transport mechanism 12 and the transport mechanism 41 deliver the substrate W to each other, the support portion 43 is located at a first position P1. The first position P1 is located in the slider portion 3.

When the transport mechanism 12 and the transport mechanism 41 deliver the substrate W to each other, the support portion 43 stands still. When the transport mechanism 12 and the transport mechanism 41 deliver the substrate W to each other, the transport mechanism 12 moves. The transport mechanism 12 places the substrate W on the transport mechanism 41. The transport mechanism 12 takes the substrate W on the transport mechanism 41.

When the transport mechanism 12 and the transport mechanism 41 deliver the substrate W to each other, the contact portion 46 does not interfere with the transport mechanism 12. When the transport mechanism 12 and the transport mechanism 41 deliver the substrate W to each other, the contact portion 46 does not overlap with the hand 18 of the transport mechanism 12 in plan view. When the transport mechanism 12 and the transport mechanism 41 deliver the substrate W to each other, the hand 18 of the transport mechanism 12 is located outward of the contact portion 46 in plan view.

When the transport mechanism 12 and the transport mechanism 41 deliver the substrate W to each other, the guard 47 does not interfere with the transport mechanism 12. When the transport mechanism 12 and the transport mechanism 41 deliver the substrate W to each other, the guard 47 does not overlap with the hand 18 of the transport mechanism 12 in plan view. When the transport mechanism 12 and the transport mechanism 41 deliver the substrate W to each other, the hand 18 of the transport mechanism 12 is located inward of the guard 47 in plan view. When the transport mechanism 12 and the transport mechanism 41 deliver the substrate W to each other, the hand 18 of the transport mechanism 12 is located between the guard 47a and the contact portion 46 and between the guard 47b and the contact portion 46 in plan view.

The transport mechanism 23 and the transport mechanism 41 deliver the substrate W to each other. The transport mechanism 23 and the transport mechanism 41 may deliver a plurality of substrates W to each other at a time.

For example, the transport mechanism 24 and the transport mechanism 41 deliver the substrate W to each other. The transport mechanism 24 and the transport mechanism 41 may deliver a plurality of substrates W to each other at a time.

When the transport mechanism 23 and the transport mechanism 41 deliver the substrate W to each other, a part of the transport mechanism 23 enters the slider portion 3. When the transport mechanism 23 and the transport mechanism 41 deliver the substrate W to each other, the support portion of the transport mechanism 23 enters the slider portion 3.

For example, when the transport mechanism 24 and the transport mechanism 41 deliver the substrate W to each other, a part of the transport mechanism 24 enters the slider portion 3. When the transport mechanism 24 and the transport mechanism 41 deliver the substrate W to each other, the support portion 16 of the transport mechanism 24 enters the slider portion 3.

When the transport mechanism 23 and the transport mechanism 41 deliver the substrate W to each other, the support portion 43 is located at a second position P2. The second position P2 is located in the slider portion 3.

For example, when the transport mechanism 24 and the transport mechanism 41 deliver the substrate W to each other, the support portion 43 is located at the second position P2. The second position P2 is located in the slider portion 3.

When the transport mechanism 23 and the transport mechanism 41 deliver the substrate W to each other, the support portion 43 stands still. When the transport mechanism 23 and the transport mechanism 41 deliver the substrate W to each other, the transport mechanism 23 moves. The transport mechanism 23 places the substrate W on the transport mechanism 41. The transport mechanism 23 takes the substrate W on the transport mechanism 41.

For example, when the transport mechanism 24 and the transport mechanism 41 deliver the substrate W to each other, the support portion 43 stands still. When the transport mechanism 24 and the transport mechanism 41 deliver the substrate W to each other, the transport mechanism 24 moves. The transport mechanism 24 places the substrate W on the transport mechanism 41. The transport mechanism 24 takes the substrate W on the transport mechanism 41.

When the transport mechanism 23 and the transport mechanism 41 deliver the substrate W to each other, the contact portion 46 does not interfere with the transport mechanism 23. When the transport mechanism 23 and the transport mechanism 41 deliver the substrate W to each other, the contact portion 46 does not overlap with the hand of the transport mechanism 23 in plan view. When the transport mechanism 23 and the transport mechanism 41 deliver the substrate W to each other, the hand of the transport mechanism 23 is located outward of the contact portion 46.

For example, when the transport mechanism 24 and the transport mechanism 41 deliver the substrate W to each other, the contact portion 46 does not interfere with the transport mechanism 24. When the transport mechanism 24 and the transport mechanism 41 deliver the substrate W to each other, the contact portion 46 does not overlap with the hand 18 of the transport mechanism 24 in plan view. When the transport mechanism 24 and the transport mechanism 41 deliver the substrate W to each other, the hand 18 of the transport mechanism 24 is located outward of the contact portion 46.

When the transport mechanism 23 and the transport mechanism 41 deliver the substrate W to each other, the guard 47 does not interfere with the transport mechanism 23. When the transport mechanism 23 and the transport mechanism 41 deliver the substrate W to each other, the guard 47 does not overlap with the hand of the transport mechanism 23 in plan view. When the transport mechanism 23 and the transport mechanism 41 deliver the substrate W to each other, the hand of the transport mechanism 23 is located inward of the guard 47. When the transport mechanism 23 and the transport mechanism 41 deliver the substrate W to each other, the hand of the transport mechanism 23 is located between the guard 47a and the contact portion 46 and between the guard 47b and the contact portion 46 in plan view.

For example, when the transport mechanism 24 and the transport mechanism 41 deliver the substrate W to each other, the guard 47 does not interfere with the transport mechanism 24. When the transport mechanism 24 and the transport mechanism 41 deliver the substrate W to each other, the guard 47 does not overlap with the hand 18 of the transport mechanism 24 in plan view. When the transport mechanism 24 and the transport mechanism 41 deliver the substrate W to each other, the hand 18 of the transport mechanism 24 is located inward of the guard 47. When the transport mechanism 24 and the transport mechanism 41 deliver the substrate W to each other, the hand 18 of the transport mechanism 24 is located between the guard 47a and the contact portion 46 and between the guard 47b and the contact portion 46 in plan view.

### <5. First front portion 5, first rear portion 6, second front portion 7, and second rear portion 8>

Reference is made to FIG. 4. As described above, the first front portion 5 includes the processing units 50 and the transport mechanism 55. The first front portion 5 further includes a placing portion 54. The transport mechanism 55 transports the substrate W to the processing units 50 and the placing portion 54. The processing units 50 include a plurality of first processing units 51, a plurality of second processing units 52, and a plurality of third processing units 53. The plurality of first processing units 51 process a plurality of substrates W in parallel. The plurality of second processing units 52 process a plurality of substrates W in parallel. The plurality of third processing units 53 process a plurality of substrates W in parallel.

Each of the first rear portion 6, the second front portion 7, and the second rear portion 8 has a configuration similar to that of the first front portion 5.

As described above, the first rear portion 6 includes the processing unit 60 and the transport mechanism 65. The first rear portion 6 further includes a placing portion 64. The transport mechanism 65 transports the substrate W to the processing unit 60 and the placing portion 64. The processing units 60 include a plurality of first processing units 61, a plurality of second processing units 62, and a plurality of third processing units 63.

Reference is made to FIG. 6. As described above, the second front portion 7 includes the processing unit 70 and the transport mechanism 75. The second front portion 7 further includes a placing portion 74. The transport mechanism 75 transports the substrate W to the processing unit 70 and the placing portion 74. The processing units 70 include a plurality of first processing units 71, a plurality of second processing units 72, and a plurality of third processing units 73.

As described above, the second rear portion 8 includes the processing unit 80 and the transport mechanism 85. The second rear portion 8 further includes a placing portion 84. The transport mechanism 85 transports the substrate W to the processing unit 80 and the placing portion 84. The processing units 80 include a plurality of first processing units 81, a plurality of second processing units 82, and a plurality of third processing units 83.

The placing portion 54 is an example of a first front placing portion of the present invention. The placing portion 64 is an example of a first rear placing portion of the present invention. The placing portion 74 is an example of a second front placing portion of the present invention. The placing portion 84 is an example of a second rear placing portion of the present invention.

The processing unit 50 processes the substrate W. For example, the first processing unit 51 processes the substrate W. The second processing unit 52 processes the substrate W. The third processing unit 53 processes the substrate W. Similarly, each of the processing units 60, 70, and 80 processes the substrate W.

The processing unit 50 processes one substrate W at a time. For example, the first processing unit 51 processes one substrate W at a time. The second processing unit 52 processes one substrate W at a time. The third processing unit 53 processes one substrate W at a time. Similarly, each of the processing units 60, 70, and 80 processes one substrate W at a time.

The first processing unit 51 will be described. The first processing unit 51 performs non-liquid processing on the substrate W.

Reference is made to FIG. 7. For example, some of the first processing units 51 are classified as an adhesion reinforcing processing units PAHP. The adhesion reinforcing processing unit PAHP performs adhesion reinforcing processing. The adhesion reinforcing processing is for improving adhesion between the substrate W and a coating film. For example, the adhesion reinforcing processing unit PAHP supplies hexamethyldisilazane (HMDS) to the substrate W and adjusts a temperature of the substrate W to a predetermined temperature. Other first processing units 51 are classified as heating and cooling units PHP. The heating and cooling unit PHP heats the substrate W and then cools the substrate W.

Reference is made to FIG. 4. Each of the first processing units 51 includes one or two support members 91. The support member 91 supports the substrate W in a horizontal posture. The support member 91 includes, for example, at least one of a horizontal plate or a vertical pin. Each of the first processing units 51 may include a heater (not illustrated). The heater heats the substrate W on the support member 91. Each of the first processing units 51 may include a cooler (not illustrated). The cooler cools the substrate W on the support member 91. When the first processing unit 51 includes two support members 91, the first processing unit 51 may further include a local transport mechanism (not illustrated). The local transport mechanism transports the substrate W between the two support members 91.

The first processing unit 61 has the same structure as the first processing unit 51. Similarly, each of the first processing units 71 and 81 has the same structure as the first processing unit 51.

The second processing unit 52 will be described. The second processing unit 52 performs liquid processing on the substrate W. The second processing unit 52 supplies a processing liquid to the substrate W.

For example, the second processing unit 52 forms a coating film on the substrate W. For example, the second processing unit 52 supplies a resist liquid to the substrate W to form a resist film on the substrate W.

The second processing unit 52 includes a holding portion 92a and a cup 92b. The holding portion 92a holds the substrate W in a horizontal posture. The holding portion 92a holds the substrate W. The holding portion 92a suctions, for example, a back surface of the substrate W. The holding portion 92a holds only a center of the back surface of the substrate W with a vacuum suction force. The holding portion 92a is, for example, a vacuum chuck. The substrate W held by the holding portion 92a takes a horizontal posture. The holding portion 92a is configured to be able to rotate the substrate W. The cup 92b surrounds the holding portion 92a. The cup 92b has a tubular shape. The cup 92b receives liquid scattered from the substrate W.

The second processing unit 52 includes one or more nozzles 92c and a nozzle transport mechanism 92d. The nozzle 92c dispenses the processing liquid. For example, the nozzle 92c is shared by a plurality of (for example, two) second processing units 52. The plurality of second processing units 52 are installed in one chamber without being partitioned from one another. The nozzle transport mechanism 92d moves the nozzle 92c between a standby position and a processing position. The standby position is a position outward of the cup 92b. The processing position is a position upward of the substrate W held by the holding portion 92a. When the nozzle 92c is located at the processing position, the nozzle 92c dispenses the processing liquid to the substrate W.

The second processing unit 62 has the same structure as the second processing unit 52. Similarly, each of the second processing units 72 and 82 has the same structure as the second processing unit 52.

The third processing unit 53 will be described. The third processing unit 53 performs non-liquid processing on the substrate W.

For example, the third processing unit 53 is classified as a cooling unit CP. The cooling unit CP cools the substrate W.

Each of the third processing units 53 includes one support member 93. The support member 93 supports the substrate W in a horizontal posture. The support member 93 includes, for example, at least one of a horizontal plate or a vertical pin. Each of the third processing units 53 includes a cooler (not illustrated). The cooler cools the substrate W on the support member 93.

The third processing unit 63 has the same structure as the third processing unit 53. Similarly, each of the third processing units 73 and 83 has the same structure as the third processing unit 53.

The placing portion 54 will be described. A plurality of (for example, four) substrates W are placed on the placing portion 54 at a time. The placing portion 54 supports the substrate W in a horizontal posture. The plurality of substrates W on the placing portion 54 are arranged in the vertical direction Z. Although not illustrated, the placing portion 54 includes, for example, at least one of a horizontal plate, a support pin, or a shelf.

The placing portion 64 has the same structure as the placing portion 54. Similarly, each of the placing portions 74 and 84 has the same structure as the placing portion 54.

The transport mechanism 55 is, for example, a transport robot. The transport mechanism 65 is, for example, a transport robot. The transport mechanism 75 is, for example, a transport robot. The transport mechanism 85 is, for example, a transport robot.

The transport mechanism 55 will be described. The transport mechanism 55 has the same structure as the transport mechanism 25. For example, the transport mechanism 55 includes a support column 33, a lift portion 34, a rotation portion 35, and a support portion 36. The support portion 36 includes a plurality of hands 38.

The transport mechanism 55 does not reach the indexer portion 2. The support portion 36 of the transport mechanism 55 does not enter the indexer portion 2.

The transport mechanism 55 does not reach the slider portion 3. The support portion 36 of the transport mechanism 55 does not enter the slider portion 3.

The transport mechanism 55 does not reach the bridge portion 4. The support portion 36 of the transport mechanism 55 does not enter the bridge portion 4.

The transport mechanism 65 has the same structure as the transport mechanism 55. Similarly, each of the transport mechanisms 75 and 85 has the same structure as the transport mechanism 55.

### <6. Cabinet portion>

Reference is made to FIG. 4. The substrate processing apparatus 1 further includes a cabinet portion 9. The cabinet portion 9 supplies a processing liquid to the first front portion 5, the first rear portion 6, the second front portion 7, and the second rear portion 8. The cabinet portion 9 supplies the processing liquid to the processing units 50, 60, 70, and 80. The cabinet portion 9 supplies the processing liquid to the second processing units 52, 62, 72, and 82. The cabinet portion 9 supplies the processing liquid to the nozzle 92c.

The cabinet portion 9 includes, for example, one or more processing liquid containers 101. The processing liquid container 101 stores the processing liquid. The processing liquid container 101 supplies the processing liquid to the nozzle 92c.

Reference is made to FIG. 2. The controller 10 further controls the transport mechanism 12 of the indexer portion 2. The controller 10 controls the transport mechanism 41 of the slider portion 3. The controller 10 controls the transport mechanism 23 of the bridge portion 4. Specifically, the controller 10 controls the transport mechanisms 24, 25, and 26.

### <7. Disposition>

Reference is made to FIG. 9. For convenience, the plurality of carrier stages 11 are referred to as carrier stages 11a, 11b, 11c, and 11d in order to distinguish from one another. The carrier stage 11a is disposed on the first side of the transport mechanism 12 in the width direction Y. The carrier stage 11b is disposed on the second side of the transport mechanism 12 in the width direction Y. The carrier stage 11c is disposed on the first side of the transport mechanism 12 in the width direction Y. The carrier stage 11c is disposed upward of the carrier stage 11a in the vertical direction Z. The carrier stage 11d is disposed on the second side of the transport mechanism 12 in the width direction Y. The carrier stage 11d is disposed upward of the carrier stage 11b in the vertical direction Z.

Reference is made to FIG. 4. The carrier stage 11 and the transport mechanism 12 are arranged in the width direction Y. The carrier stage 11a, the transport mechanism 12, and the carrier stage 11b are arranged in this order in the width direction Y. The carrier stage 11a and the carrier stage 11b face each other.

The carrier stage 11 and the transport mechanism 12 are not arranged in the front-rear direction X. The carrier stage 11 is not disposed frontward of the transport mechanism 12 in the front-rear direction X.

The first processing unit 51, the transport mechanism 55, and the second processing units 52 are arranged in this order in the width direction Y. The first processing unit 51 is disposed on the first side of the transport mechanism 55. The second processing unit 52 is disposed on the second side of the transport mechanism 55.

The third processing unit 53, the transport mechanism 55, and the placing portion 54 are arranged in this order in the front-rear direction X. The third processing unit 53 is disposed frontward of the transport mechanism 55. The placing portion 54 is disposed rearward of the transport mechanism 55.

The bridge portion 4 and the cabinet portion 9 are arranged in the width direction Y. The cabinet portion 9 is disposed on the second side of the bridge portion 4.

The placing portion 21, the transport mechanism 24, and the transport mechanism 25 are arranged in a triangular shape in plan view. The placing portion 21, the transport mechanism 24, and the transport mechanism 25 are individually located at apexes of a virtual triangle (specifically, an acute-angle triangle) in plan view.

The placing portion 21 and the transport mechanism 25 are arranged in the width direction Y. The transport mechanism 25 is disposed on the first side of the placing portion 21.

The transport mechanism 24 and the transport mechanism 25 are arranged in the width direction Y. The transport mechanism 25 is disposed on the first side of the transport mechanism 24.

The transport mechanism 24 and the placing portion 21 are arranged in the front-rear direction X. The placing portion 21 is disposed rearward of the transport mechanism 24.

The first processing unit 61, the transport mechanism 65, and the second processing unit 62 are arranged in this order in the width direction Y. The first processing unit 61 is disposed on the first side of the transport mechanism 65. The second processing unit 62 is disposed on the second side of the transport mechanism 65.

The placing portion 64, the transport mechanism 65, and the third processing unit 63 are arranged in this order in the front-rear direction X. The placing portion 64 is disposed frontward of the transport mechanism 65. The third processing unit 63 is disposed rearward of the transport mechanism 65.

The indexer portion 2, the first front portion 5, the bridge portion 4, and the first rear portion 6 are arranged in this order in the front-rear direction X. The indexer portion 2, the first front portion 5, the bridge portion 4, and the first rear portion 6 are arranged in a line.

The transport mechanism 12, the third processing unit 53, the transport mechanism 55, the placing portion 54, the transport mechanism 24, the placing portion 21, the placing portion 64, the transport mechanism 65, and the third processing unit 63 are arranged in this order in the front-rear direction X.

The carrier stage 11a, the first processing unit 51, the transport mechanism 25, and the first processing unit 61 are arranged in this order in the front-rear direction X.

The carrier stage 11b, the second processing unit 52, the cabinet portion 9, and the second processing unit 62 are arranged in this order in the front-rear direction X.

A length of the bridge portion 4 in the width direction Y is shorter than a length of the first front portion 5 in the width direction Y.

The length of the bridge portion 4 in the width direction Y is shorter than a length of the first rear portion 6 in the width direction Y.

A total length of the bridge portion 4 and the cabinet portion 9 in the width direction Y is equal to the length of the first front portion 5 in the width direction Y.

The total length of the bridge portion 4 and the cabinet portion 9 in the width direction Y is equal to the length of the first rear portion 6 in the width direction Y.

The length of the bridge portion 4 in the width direction Y is longer than a length of the cabinet portion 9 in the width direction Y.

A length of the bridge portion 4 in the front-rear direction X is equal to a length of the cabinet portion 9 in the front-rear direction X.

Reference is made to FIG. 5. The slider portion 3, the transport mechanism 55, and the second processing units 52 are arranged in this order in the width direction Y. The slider portion 3 is disposed on the first side of the transport mechanism 55.

The indexer portion 2, the slider portion 3, the bridge portion 4, and the first rear portion 6 are arranged in this order in the front-rear direction X. The indexer portion 2, the slider portion 3, the bridge portion 4, and the first rear portion 6 are arranged in a line.

The carrier stage 11a, the slider portion 3, and the transport mechanism 25 are arranged in this order in the front-rear direction X.

The slider portion 3 is disposed rearward of the transport mechanism 12 and on the first side of the transport mechanism 12.

The slider portion 3 is disposed frontward of the transport mechanism 24 and on the first side of the transport mechanism 24.

The slider portion 3 is disposed frontward of the transport mechanism 25.

A length of the slider portion 3 in the width direction Y is shorter than the length of the bridge portion 4 in the width direction Y. Therefore, the length of the slider portion 3 in the width direction Y is shorter than the length of the first front portion 5 in the width direction Y. The length of the slider portion 3 in the width direction Y is shorter than the length of the first rear portion 6 in the width direction Y.

Reference is made to FIG. 6. The carrier stage 11c, the transport mechanism 12, and the carrier stage 11d are arranged in this order in the width direction Y. The carrier stage 11c and the carrier stage 11d face each other.

The first processing unit 71, the transport mechanism 75, and the second processing unit 72 are arranged in this order in the width direction Y. The first processing unit 71 is disposed on the first side of the transport mechanism 75 in the width direction Y. The second processing unit 72 is disposed on the second side of the transport mechanism 75 in the width direction Y.

The third processing unit 73, the transport mechanism 75, and the placing portion 74 are arranged in this order in the front-rear direction X. The third processing unit 73 is disposed frontward of the transport mechanism 75. The placing portion 74 is disposed rearward of the transport mechanism 75.

The placing portion 22, the transport mechanism 24, and the transport mechanism 26 are arranged in a triangular shape in plan view. The placing portion 22, the transport mechanism 24, and the transport mechanism 26 are individually located at apexes of a virtual triangle (specifically, an acute-angle triangle) in plan view.

The placing portion 22 and the transport mechanism 26 are arranged in the width direction Y. The transport mechanism 26 is disposed on the first side of the placing portion 22.

The transport mechanism 24 and the transport mechanism 26 are arranged in the width direction Y. The transport mechanism 26 is disposed on the first side of the transport mechanism 24.

The transport mechanism 24 and the placing portion 22 are arranged in the front-rear direction X. The placing portion 22 is disposed rearward of the transport mechanism 24.

The first processing unit 81, the transport mechanism 85, and the second processing unit 82 are arranged in this order in the width direction Y. The first processing unit 81 is disposed on the first side of the transport mechanism 85 in the width direction Y. The second processing unit 82 is disposed on the second side of the transport mechanism 85 in the width direction Y.

The placing portion 84, the transport mechanism 85, and the third processing unit 83 are arranged in this order in the front-rear direction X. The placing portion 84 is disposed frontward of the transport mechanism 85. The third processing unit 83 is disposed rearward of the transport mechanism 85.

The indexer portion 2, the second front portion 7, the bridge portion 4, and the second rear portion 8 are arranged in this order in the front-rear direction X. The indexer portion 2, the second front portion 7, the bridge portion 4, and the second rear portion 8 are arranged in a line.

The transport mechanism 12, the third processing unit 73, the transport mechanism 75, the placing portion 74, the transport mechanism 24, the placing portion 22, the placing portion 84, the transport mechanism 85, and the third processing unit 83 are arranged in this order in the front-rear direction X.

The carrier stage 11c, the first processing unit 71, the transport mechanism 26, and the first processing unit 81 are arranged in this order in the front-rear direction X.

The carrier stage 11d, the second processing unit 72, the cabinet portion 9, and the second processing unit 82 are arranged in this order in the front-rear direction X.

The length of the bridge portion 4 in the width direction Y is shorter than a length of the second front portion 7 in the width direction Y. The length of the bridge portion 4 in the width direction Y is shorter than a length of the second rear portion 8 in the width direction Y.

As described above, the length of the slider portion 3 in the width direction Y is shorter than the length of the bridge portion 4 in the width direction Y. Therefore, the length of the slider portion 3 in the width direction Y is shorter than the length of the second front portion 7 in the width direction Y. The length of the slider portion 3 in the width direction Y is shorter than the length of the second rear portion 8 in the width direction Y.

The total length of the bridge portion 4 and the cabinet portion 9 in the width direction Y is equal to the length of the second front portion 7 in the width direction Y. The total length of the bridge portion 4 and the cabinet portion 9 in the width direction Y is equal to the length of the second rear portion 8 in the width direction Y.

Reference is made to FIGS. 4 to 6. The carrier stage 11a and the carrier stage 11c overlap with each other in plan view. The carrier stage 11b and the carrier stage 11d overlap with each other in plan view.

The placing portion 21 and the placing portion 22 overlap with each other in plan view. The transport mechanism 25 and the transport mechanism 26 overlap with each other in plan view.

The first front portion 5 and the second front portion 7 overlap with each other in plan view. Specifically, the processing unit 50 and the processing unit 70 overlap with each other in plan view. The first processing unit 51 and the first processing unit 71 overlap with each other in plan view. The second processing unit 52 and the second processing unit 72 overlap with each other in plan view. The third processing unit 53 and the third processing unit 73 overlap with each other in plan view. The placing portion 54 and the placing portion 74 overlap with each other in plan view. The transport mechanism 55 and the transport mechanism 75 overlap with each other in plan view.

Similarly, the first rear portion 6 and the second rear portion 8 overlap with each other each other in plan view.

The slider portion 3 overlaps with the first front portion 5 in plan view.

The slider portion 3 overlaps with the processing unit 50 in plan view. The entire slider portion 3 overlaps with the processing unit 50 in plan view.

The slider portion 3 overlaps with the first processing unit 51 in plan view. The entire slider portion 3 overlaps with the first processing unit 51 in plan view.

The slider portion 3 does not overlap with the second processing unit 52 in plan view. The slider portion 3 does not overlap with the third processing unit 53 in plan view. The slider portion 3 does not overlap with the placing portion 54 in plan view. The slider portion 3 does not overlap with the transport mechanism 55 in plan view.

The slider portion 3 overlaps with the second front portion 7 in plan view.

The slider portion 3 overlaps with the processing unit 70 in plan view. The entire slider portion 3 overlaps with the processing unit 70 in plan view.

The slider portion 3 overlaps with the first processing unit 71 in plan view. The entire slider portion 3 overlaps with the first processing unit 71 in plan view.

The slider portion 3 does not overlap with the second processing unit 72 in plan view. The slider portion 3 does not overlap with the third processing unit 73 in plan view. The slider portion 3 does not overlap with the placing portion 74 in plan view. The slider portion 3 does not overlap with the transport mechanism 75 in plan view.

The slider portion 3 does not overlap with the indexer portion 2 in plan view.

The slider portion 3 does not overlap with the bridge portion 4 in plan view.

The slider portion 3 does not overlap with the first rear portion 6 in plan view. The slider portion 3 does not overlap with the processing unit 60 in plan view. The slider portion 3 does not overlap with the placing portion 64 in plan view. The slider portion 3 does not overlap with the transport mechanism 65 in plan view.

The slider portion 3 does not overlap with the second rear portion 8 in plan view. The slider portion 3 does not overlap with the processing unit 80 in plan view. The slider portion 3 does not overlap with the placing portion 84 in plan view. The slider portion 3 does not overlap with the transport mechanism 85 in plan view.

The indexer portion 2 does not overlap with the bridge portion 4 in plan view.

The indexer portion 2 does not overlap with the first front portion 5 in plan view. The indexer portion 2 does not overlap with the first rear portion 6 in plan view. The indexer portion 2 does not overlap with the second front portion 7 in plan view. The indexer portion 2 does not overlap with the second rear portion 8 in plan view.

The bridge portion 4 does not overlap with the first front portion 5 in plan view. The bridge portion 4 does not overlap with the first rear portion 6 in plan view. The bridge portion 4 does not overlap with the second front portion 7 in plan view. The bridge portion 4 does not overlap with the second rear portion 8 in plan view.

Reference is made to FIG. 14. When the transport mechanism 12 and the transport mechanism 41 deliver the substrate W to each other, the support portion 43 overlaps with the processing unit 50 in plan view. When the transport mechanism 12 and the transport mechanism 41 deliver the substrate W to each other, the support portion 43 overlaps with the first processing unit 51 in plan view.

When the support portion 43 is located at the first position P1, the support portion 43 overlaps with the processing unit 50 in plan view. When the support portion 43 is located at the first position P1, the support portion 43 overlaps with the first processing unit 51 in plan view.

When the transport mechanism 23 and the transport mechanism 41 deliver the substrate W to each other, the support portion 43 overlaps with the processing unit 50 in plan view. When the transport mechanism 23 and the transport mechanism 41 deliver the substrate W to each other, the support portion 43 overlaps with the first processing unit 51 in plan view.

For example, when the transport mechanism 24 and the transport mechanism 41 deliver the substrate W to each other, the support portion 43 overlaps with the processing unit 50 in plan view. When the transport mechanism 24 and the transport mechanism 41 deliver the substrate W to each other, the support portion 43 overlaps with the first processing unit 51 in plan view.

When the support portion 43 is located at the second position P2, the support portion 43 overlaps with the processing unit 50 in plan view. When the support portion 43 is located at the second position P2, the support portion 43 overlaps with the first processing unit 51 in plan view.

The first position P1 and the second position P2 are arranged in the front-rear direction X. The second position P2 is disposed rearward of the first position P1.

The support portion 43 reciprocates between the first position P1 and the second position P2.

FIG. 14 illustrates a transport distance L. The transport distance L is a transport distance of the substrate W in the slider portion 3. The transport distance L is, for example, a distance between the first position P1 and the second position P2 in the front-rear direction X.

The transport distance L is relatively short.

FIG. 14 illustrates a distance K. The distance K is a distance between the indexer portion 2 and the bridge portion 4 in the front-rear direction X. The distance K corresponds to a distance of the first front portion 5 in the front-rear direction X. The transport distance L is shorter than the distance K.

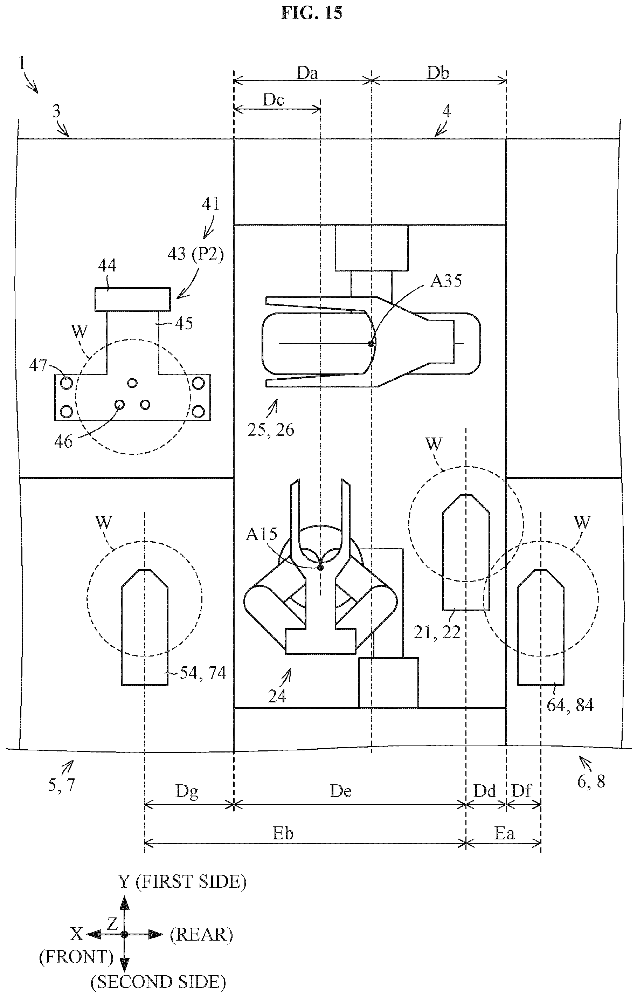

FIG. 15 is a detailed plan view of the bridge portion 4. The transport mechanism 25 is disposed at a center of the bridge portion 4 in the front-rear direction X. For example, the rotation axis A35 of the transport mechanism 25 is disposed at the center of the bridge portion 4 in the front-rear direction X.

FIG. 15 illustrates distances Da and Db. The distance Da is a distance between the transport mechanism 25 and the first front portion 5 in the front-rear direction X. The distance Db is a distance between the transport mechanism 25 and the first rear portion 6 in the front-rear direction X. The distance Da is equal to the distance Db.

The transport mechanism 24 is disposed frontward of the transport mechanism 25. For example, the rotation axis A15 of the transport mechanism 24 is disposed frontward of the rotation axis A35 of the transport mechanism 25.

The transport mechanism 24 is closer to the slider portion 3 than the center of the bridge portion 4 in the front-rear direction X. The transport mechanism 24 is closer to the slider portion 3 than the transport mechanism 25 in the front-rear direction X.

FIG. 15 illustrates a distance Dc. The distance Dc is a distance between the transport mechanism 24 and the slider portion 3 in the front-rear direction X. The distance Da corresponds to a distance between the center of the bridge portion 4 and the slider portion 3 in the front-rear direction X. The distance Da corresponds to a distance between the transport mechanism 25 and the slider portion 3 in the front-rear direction X. The distance Dc is shorter than the distance Da.

The placing portion 21 is disposed rearward of the transport mechanism 25. For example, the placing portion 21 is disposed rearward of the rotation axis A35 of the transport mechanism 25. The placing portion 21 is closer to the first rear portion 6 than the center of the bridge portion 4 in the front-rear direction X.

FIG. 15 illustrates a distance Dd. The distance Dd is a distance between the placing portion 21 and the first rear portion 6 in the front-rear direction X. The distance Db corresponds to a distance between the center of the bridge portion 4 and the first rear portion 6 in the front-rear direction X. The distance Dd is shorter than the distance Db.

The placing portion 21 is close to the first rear portion 6. The substrate W placed on the placing portion 21 overlaps with the first rear portion 6 in plan view. A part of the substrate W placed on the placing portion 21 overlaps with the first rear portion 6 in plan view. The placing portion 21 does not overlap with the first rear portion 6 in plan view.

The distance Dd is shorter than a radius of the substrate W.

The placing portion 21 is closer to the first rear portion 6 than the first front portion 5 in the front-rear direction X.

FIG. 15 illustrates a distance De. The distance De is a distance between the placing portion 21 and the first front portion 5 in the front-rear direction X. The distance Dd is shorter than the distance De.

The placing portion 64 is close to the bridge portion 4. The substrate W placed on the placing portion 64 overlaps with the bridge portion 4 in plan view. A part of the substrate W placed on the placing portion 64 overlaps with the bridge portion 4 in plan view. The placing portion 64 does not overlap with the bridge portion 4 in plan view.

FIG. 15 illustrates a distance Df. The distance Df is a distance between the placing portion 64 and the bridge portion 4 in the front-rear direction X. The distance Df is shorter than the radius of the substrate W.

The placing portion 64 is closer to the bridge portion 4 than the placing portion 54.

FIG. 15 illustrates a distance Dg. The distance Dg is a distance between the placing portion 54 and the bridge portion 4 in the front-rear direction X. The distance Df is shorter than the distance Dg.

The substrate W placed on the placing portion 54 does not overlap with the bridge portion 4 in plan view. The placing portion 54 does not overlap with the bridge portion 4 in plan view. The distance Dg is longer than the radius of the substrate W.

The placing portion 21 is close to the placing portion 64. The substrate W placed on the placing portion 21 overlaps with the substrate W placed on the placing portion 64 in plan view. A part of the substrate W placed on the placing portion 21 overlaps with a part of the substrate W placed on the placing portion 64 in plan view.

FIG. 15 illustrates a distance Ea. The distance Ea is a distance between the placing portion 21 and the placing portion 64 in the front-rear direction X. The distance Ea is shorter than a diameter of the substrate W.

The placing portion 21 is closer to the placing portion 64 than the placing portion 54. The substrate W placed on the placing portion 21 does not overlap with the substrate W placed on the placing portion 54 in plan view.

FIG. 15 illustrates a distance Eb. The distance Eb is a distance between the placing portion 21 and the placing portion 54 in the front-rear direction X. The distance Ea is shorter than the distance Eb. The distance Eb is longer than a diameter of the substrate W.

The substrate W placed on the placing portion 54 does not overlap with the substrate W placed on the placing portion 64 in plan view.

The transport mechanism 26 is disposed at the same position as the transport mechanism 25 in plan view. The placing portion 22 is disposed at the same position as the placing portion 21 in plan view. The placing portion 74 is disposed at the same position as the placing portion 54 in plan view. The placing portion 84 is disposed at the same position as the placing portion 64 in plan view.

Reference is made to FIG. 7. The processing unit 70 is disposed upward of the processing unit 50.

The processing unit 50, the slider portion 3, and the processing unit 70 are arranged in this order in the vertical direction Z. The processing unit 50 is disposed downward of the slider portion 3. The processing unit 70 is disposed upward of the slider portion 3. The slider portion 3 is disposed between the processing unit 50 and the processing unit 70.

The first processing units 51 and 71 are arranged in the vertical direction Z. The first processing unit 71 is disposed upward of the first processing unit 51.

The plurality of first processing units 51 are arranged in the front-rear direction X and the vertical direction Z. The plurality of first processing units 71 are arranged in the front-rear direction X and the vertical direction Z.

The first processing unit 51, the slider portion 3, and the first processing unit 71 are arranged in this order in the vertical direction Z. The first processing unit 51 is disposed downward of the slider portion 3. The first processing unit 71 is disposed upward of the slider portion 3. The slider portion 3 is disposed between the first processing unit 51 and the first processing unit 71.

The transport mechanisms 25 and 26 are arranged in the vertical direction Z. The transport mechanism 26 is disposed upward of the transport mechanism 25.

The transport mechanism 25 is disposed at a height position same as a height position of the first front portion 5. The transport mechanism 25 is disposed at a height position same as a height position of the first rear portion 6.

The transport mechanism 26 is disposed at a height position same as a height position of the second front portion 7. The transport mechanism 26 is disposed at a height position same as a height position of the second rear portion 8.

The processing unit 80 is disposed upward of the processing unit 60.

The first processing units 61 and 81 are arranged in the vertical direction Z. The first processing unit 81 is disposed upward of the first processing unit 61.

The plurality of first processing units 61 are arranged in the front-rear direction X and the vertical direction Z. The plurality of first processing units 81 are arranged in the front-rear direction X and the vertical direction Z.

At least one first processing unit 51 is in contact with the bridge portion 4. For example, the adhesion reinforcing processing unit PAHP in the first processing units 51 is in contact with the bridge portion 4.

At least one first processing unit 51 is adjacent to the transport mechanism 25. For example, the adhesion reinforcing processing unit PAHP in the first processing units 51 is adjacent to the transport mechanism 25.

At least one first processing unit 61 is in contact with the bridge portion 4. For example, the adhesion reinforcing processing unit PAHP in the first processing units 61 is in contact with the bridge portion 4.

At least one first processing unit 61 is adjacent to the transport mechanism 25. For example, the adhesion reinforcing processing unit PAHP in the first processing units 61 is adjacent to the transport mechanism 25.

At least one first processing unit 71 is in contact with the bridge portion 4. For example, the adhesion reinforcing processing unit PAHP in the first processing units 71 is in contact with the bridge portion 4.

At least one first processing unit 71 is adjacent to the transport mechanism 26. For example, the adhesion reinforcing processing unit PAHP in the first processing units 71 is adjacent to the transport mechanism 26.

At least one first processing unit 81 is in contact with the bridge portion 4. For example, the adhesion reinforcing processing unit PAHP in the first processing units 81 is in contact with the bridge portion 4.

At least one first processing unit 81 is adjacent to the transport mechanism 26. For example, the adhesion reinforcing processing unit PAHP in the first processing units 81 is adjacent to the transport mechanism 26.

Reference is made to FIG. 8.

The second processing units 52 and 72 are arranged in the vertical direction Z. The second processing unit 72 is disposed upward of the second processing unit 52.

The plurality of second processing units 52 are arranged in the front-rear direction X and the vertical direction Z. The plurality of second processing units 72 are arranged in the front-rear direction X and the vertical direction Z.

The second processing units 62 and 82 are arranged in the vertical direction Z. The second processing unit 82 is disposed upward of the second processing unit 62.

The plurality of second processing units 62 are arranged in the front-rear direction X and the vertical direction Z. The plurality of second processing units 82 are arranged in the front-rear direction X and the vertical direction Z.

At least one second processing unit 52 is in contact with the cabinet portion 9.

At least one second processing unit 62 is in contact with the cabinet portion 9.

At least one second processing unit 72 is in contact with the cabinet portion 9.

At least one second processing unit 82 is in contact with the cabinet portion 9.

Reference is made to FIG. 9. In FIG. 9, the slider portion 3 is indicated by a broken line for convenience. In front view, the slider portion 3 is disposed on the first side of the transport mechanism 12. In front view, the slider portion 3 does not overlap with the rotation portion 15 of the transport mechanism 12. In front view, the slider portion 3 does not overlap with the rotation axis A15 of the transport mechanism 12.

In front view, the carrier stage 11a, the slider portion 3, and the carrier stage 11c are arranged in this order in the vertical direction Z. In front view, the carrier stage 11a is disposed downward of the slider portion 3. In front view, the carrier stage 11c is disposed upward of the slider portion 3. In front view, the slider portion 3 is disposed between the carrier stage 11a and the carrier stage 11c. In front view, the slider portion 3 does not overlap with the carrier stage 11.

Reference is made to FIG. 10. The movable elements 44a and 44b are arranged in the vertical direction Z. The movable element 44b is disposed upward of the movable element 44a.

The transport mechanisms 55 and 75 are arranged in the vertical direction Z. The transport mechanism 75 is disposed upward of the transport mechanism 55.

The transport mechanism 55 is configured to move to a height position same as a height position of the slider portion 3.

For example, the slider portion 3 includes a lower portion 3a. The movable element 44a is disposed in the lower portion 3a. The transport mechanism 55 is configured to move to a height position same as a height position of the lower portion 3a.

The first processing unit 51 and the slider portion 3 are arranged in the vertical direction Z. The plurality of second processing units 52 are arranged in the vertical direction Z. At least one of the second processing units 52 is disposed at a height position same as a height position of the slider portion 3.

The second processing unit 52 includes a second processing unit 52H. The second processing unit 52H is disposed at the highest position among the plurality of second processing units 52. The second processing unit 52H is disposed at a height position same as a height position of the lower portion 3a. Therefore, the number of the second processing units 52 is relatively large.

As described above, the transport mechanism 55 is configured to move to a height position same as a height position of the slider portion 3. Therefore, it is easy for the transport mechanism 55 to transport the substrate W to the second processing unit 52H

The transport mechanism 75 is configured to move to a height position same as a height position of the slider portion 3.

For example, the slider portion 3 includes an upper portion 3b. The upper portion 3b is located upward of the lower portion 3a. The movable element 44b is disposed in the upper portion 3b. The transport mechanism 75 is configured to move to a height position same as a height position of the upper portion 3b.

The first processing unit 71 and the slider portion 3 are arranged in the vertical direction Z. The plurality of second processing units 72 are arranged in the vertical direction Z. At least one of the second processing units 72 is disposed at a height position same as a height position of the slider portion 3.

The second processing unit 72 includes a second processing unit 72L. The second processing unit 72L is disposed at the lowest position among the plurality of second processing units 72. The second processing unit 72L is disposed at a height position same as a height position of the upper portion 3b. Therefore, the number of the second processing units 72 is relatively large.

As described above, the transport mechanism 75 is configured to move to a height position same as a height position of the slider portion 3. Therefore, it is easy for the transport mechanism 75 to transport the substrate W to the second processing unit 72L

The placing portions 54 and 74 are arranged in the vertical direction Z. The placing portion 74 is disposed upward of the placing portion 54.

The placing portion 54 is disposed downward of the slider portion 3. The placing portion 74 is disposed upward of the slider portion 3.

Although not illustrated, the third processing units 53 and 73 are arranged in the vertical direction Z. The third processing unit 73 is disposed upward of the third processing unit 53.

Reference is made to FIG. 11. The placing portions 21 and 22 are arranged in the vertical direction Z. The placing portion 22 is disposed upward of the placing portion 21.

In FIG. 11, the slider portion 3 is indicated by a broken line for convenience. The placing portion 21 is disposed downward of the slider portion 3. The placing portion 22 is disposed upward of the slider portion 3.

In FIG. 11, the placing portions 54 and 74 are indicated by broken lines for convenience. The placing portion 21 is disposed upward of the placing portion 54. The placing portion 21 is disposed downward of the placing portion 74.

The placing portion 22 is disposed upward of the placing portion 74.

In FIG. 11, the placing portions 64 and 84 are indicated by broken lines for convenience. The placing portion 64 is disposed at a height position same as a height position of the placing portion 54. The placing portion 64 overlaps with the placing portion 54 in front view. The placing portion 84 is disposed at a height position same as a height position of the placing portion 74. The placing portion 84 overlaps with the placing portion 74 in front view.

The placing portion 21 is disposed upward of the placing portion 64. The placing portion 21 is disposed downward of the placing portion 84.

The placing portion 22 is disposed upward of the placing portion 84.

Reference is made to FIG. 12. The transport mechanisms 65 and 85 are arranged in the vertical direction Z. The transport mechanism 85 is disposed upward of the transport mechanism 65.

The placing portions 64 and 84 are arranged in the vertical direction Z. The placing portion 84 is disposed upward of the placing portion 64.

Although not illustrated, the third processing units 63 and 83 are arranged in the vertical direction Z. The third processing unit 83 is disposed upward of the third processing unit 63.

### <8. Operation example>

An operation example of the substrate processing apparatus 1 will be described. A substrate processing method will be described.

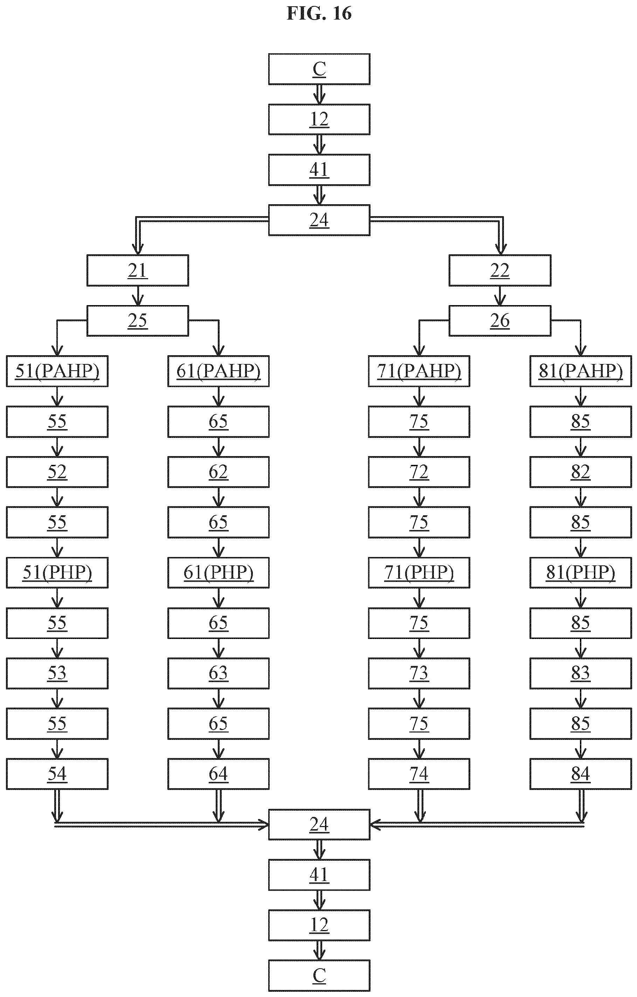

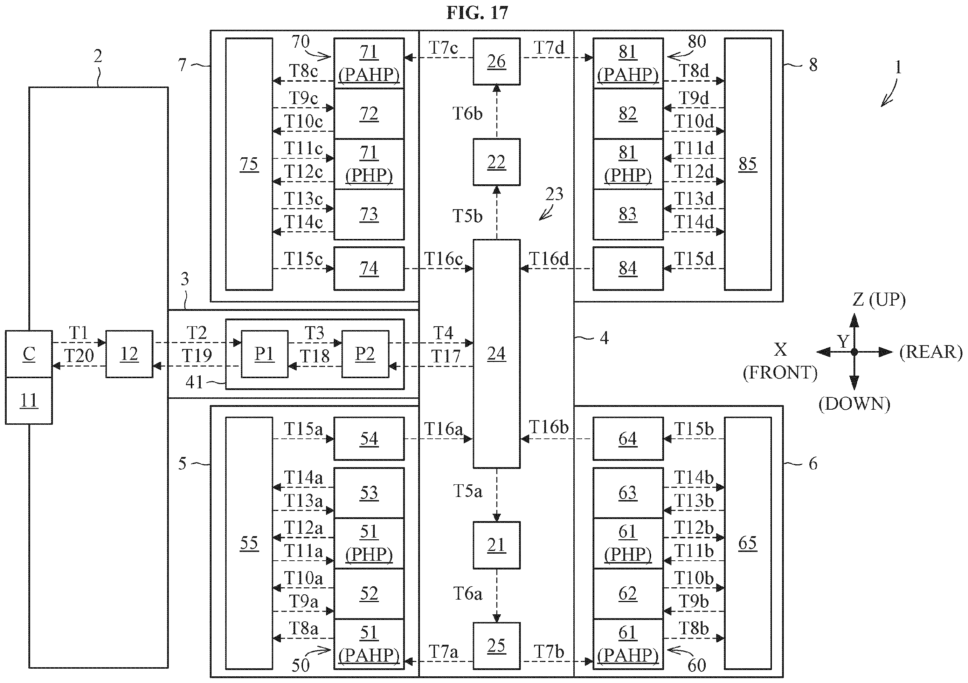

FIG. 16 is a view schematically illustrating a transport path of the substrate W. In FIG. 16, a path along which the plurality of substrates W are transported at a time is indicated by a double line. However, one substrate W may be transported at a time along the path indicated by the double line. FIG. 17 is a side view schematically illustrating an operation example of the substrate processing apparatus 1. FIG. 17 illustrates transport operations T1 to T20.

### Transport operation T1

The transport mechanism 12 takes a plurality of substrates W in the carrier C on the carrier stage 11 at a time.

### Transport operation T2

The transport mechanism 12 transports the plurality of substrates W from the indexer portion 2 to the slider portion 3 at a time. The transport mechanism 12 places the plurality of substrates W on the transport mechanism 41 at a time.

By the transport operations T1 and T2, the transport mechanism 12 transports the plurality of substrates W from the carrier C to the transport mechanism 41 at a time.

### Transport operation T3

The transport mechanism 41 transports the plurality of substrates W from the first position P1 to the second position P2 at a time. As a result, the transport mechanism 41 transports the plurality of substrates W from the indexer portion 2 to the bridge portion 4 at a time. In other words, the transport mechanism 41 transports the plurality of substrates W from the transport mechanism 12 to the transport mechanism 24 at a time.

### Transport operation T4

The transport operation T4 corresponds to the above-described "take-in".

The transport mechanism 23 takes the plurality of substrates W on the transport mechanism 41 at a time. The transport mechanism 23 transports the plurality of substrates W from the slider portion 3 to the bridge portion 4 at a time.

For example, the transport mechanism 24 takes the plurality of substrates W on the transport mechanism 41 at a time. The transport mechanism 24 transports the plurality of substrates W from the slider portion 3 to the bridge portion 4 at a time.

### Transport operations T5a and T5b

The transport mechanism 24 places the plurality of substrates W on the placing portion 21 at a time. The transport mechanism 24 places the plurality of substrates W on the placing portion 22 at a time.

By the transport operations T4 and T5a, the transport mechanism 24 transports the plurality of substrates W from the transport mechanism 41 to the placing portion 21 at a time. By the transport operations T4 and T5b, the transport mechanism 24 transports the plurality of substrates W from the transport mechanism 41 to the placing portion 22 at a time.

### Transport operation T6a

The transport mechanism 25 takes one substrate W on the placing portion 21 at a time.

### Transport operation T6b

The transport mechanism 26 takes one substrate W on the placing portion 22 at a time.

The transport mechanism 24 transports the substrate W from the transport mechanism 41 to the transport mechanism 25 by the transport operations T4, T5a, and T6a. The transport mechanism 24 transports the substrate W from the transport mechanism 41 to the transport mechanism 26 by the transport operations T4, T5b, and T6b.

### Transport operations T7a and T7b

The transport operations T7a and T7b correspond to the above-described "distribution".

The transport mechanism 23 transports the substrate W from the bridge portion 4 to the first front portion 5. A part of the transport mechanism 23 enters the first front portion 5. The support portion of the transport mechanism 23 enters the first front portion 5. The transport mechanism 23 places the substrate W in one of the first processing units 51. Specifically, the transport mechanism 23 places the substrate W in the adhesion reinforcing processing unit PAHP in the first processing units 51. Similarly, the transport mechanism 23 transports the substrate W from the bridge portion 4 to the first rear portion 6. A part of the transport mechanism 23 enters the first rear portion 6. The support portion of the transport mechanism 23 enters the first rear portion 6. The transport mechanism 23 places the substrate W in one of the first processing units 61. Specifically, the transport mechanism 23 places the substrate W in the adhesion reinforcing processing unit PAHP in the first processing units 61.

For example, the transport mechanism 25 transports the substrate W from the bridge portion 4 to the first front portion 5. A part of the transport mechanism 25 enters the first front portion 5. The support portion 36 of the transport mechanism 25 enters the first front portion 5. The transport mechanism 25 places the substrate W in one of the first processing units 51. Specifically, the transport mechanism 25 places the substrate W in the adhesion reinforcing processing unit PAHP in the first processing units 51. Similarly, the transport mechanism 25 transports the substrate W from the bridge portion 4 to the first rear portion 6. A part of the transport mechanism 25 enters the first rear portion 6. The support portion 36 of the transport mechanism 25 enters the first rear portion 6. The transport mechanism 25 places the substrate W in one of the first processing units 61. Specifically, the transport mechanism 25 places the substrate W in the adhesion reinforcing processing unit PAHP in the first processing units 61.

### Transport operations T7c and T7d

The transport operations T7c and T7d correspond to the above-described "distribution".

The transport mechanism 23 transports the substrate W from the bridge portion 4 to the second front portion 7. A part of the transport mechanism 23 enters the second front portion 7. The support portion of the transport mechanism 23 enters the second front portion 7. The transport mechanism 23 places the substrate W in one of the first processing units 71. Specifically, the transport mechanism 23 places the substrate W in the adhesion reinforcing processing unit PAHP in the first processing units 71. Similarly, the transport mechanism 23 transports the substrate W from the bridge portion 4 to the second rear portion 8. A part of the transport mechanism 23 enters the second rear portion 8. The support portion of the transport mechanism 23 enters the second rear portion 8. The transport mechanism 23 places the substrate W in one of the first processing units 81. Specifically, the transport mechanism 23 places the substrate W in the adhesion reinforcing processing unit PAHP in the first processing units 81.

For example, the transport mechanism 26 transports the substrate W from the bridge portion 4 to the second front portion 7. A part of the transport mechanism 26 enters the second front portion 7. The support portion 36 of the transport mechanism 26 enters the second front portion 7. The transport mechanism 26 places the substrate W in one of the first processing units 71. Specifically, the transport mechanism 26 places the substrate W in the adhesion reinforcing processing unit PAHP in the first processing units 71. Similarly, the transport mechanism 26 transports the substrate W from the bridge portion 4 to the second rear portion 8. A part of the transport mechanism 26 enters the second rear portion 8. The support portion 36 of the transport mechanism 26 enters the second rear portion 8. The transport mechanism 26 places the substrate W in one of the first processing units 81. Specifically, the transport mechanism 26 places the substrate W in the adhesion reinforcing processing unit PAHP in the first processing units 81.

The transport mechanism 25 transports the substrate W from the transport mechanism 24 to the first processing unit 51 by the transport operations T5a, T6a, and T7a. The transport mechanism 25 transports the substrate W from the transport mechanism 24 to the first processing unit 61 by the transport operations T5a, T6a, and T7b.

The transport mechanism 26 transports the substrate W from the transport mechanism 24 to the first processing unit 71 by the transport operations T5b, T6b, and T7c. The transport mechanism 26 transports the substrate W from the transport mechanism 24 to the first processing unit 81 by the transport operations T5b, T6b, and T7d.

An operation of the first front portion 5 will be described. The adhesion reinforcing processing unit PAHP performs adhesion reinforcing processing on the substrate W. The transport mechanism 55 takes the substrate W in the adhesion reinforcing processing unit PAHP (transport operation T8a). The transport mechanism 55 places the substrate W in the second processing unit 52 (transport operation T9a). The second processing unit 52 performs liquid processing on the substrate W. The transport mechanism 55 takes the substrate W in the second processing unit 52 (transport operation T10a). The transport mechanism 55 places the substrate W in the heating and cooling unit PHP (transport operation T11a). The heating and cooling unit PHP heats the substrate W and then cools the substrate W. The transport mechanism 55 takes the substrate W in the heating and cooling unit PHP (transport operation T12a). The transport mechanism 55 places the substrate W in the third processing unit 53 (transport operation T13a). The third processing unit 53 cools the substrate W. The transport mechanism 55 takes the substrate W in the third processing unit 53 (transport operation T14a). The transport mechanism 55 places the substrate W on the placing portion 54 (transport operation T15a).

Every time the first front portion 5 repeats the transport operation T15a, the number of substrates W placed on the placing portion 54 increases by one.

An operation of the first rear portion 6 is identical to the operation of the first front portion 5. Each of operations of the second front portion 7 and the second rear portion 8 is identical to the operation of the first front portion 5.

### Transport operations T16a, T16b, T16c, and T16d

The transport operations T16a, T16b, T16c, and T16d correspond to the above-described "collection".

A part of the transport mechanism 23 enters the first front portion 5. The support portion of the transport mechanism 23 enters the first front portion 5. The transport mechanism 23 takes a plurality of substrates W on the placing portion 54 at a time. The transport mechanism 23 transports the plurality of substrates W from the first front portion 5 to the bridge portion 4 at a time. Similarly, a part of the transport mechanism 23 enters the first rear portion 6. The support portion of the transport mechanism 23 enters the first rear portion 6. The transport mechanism 23 takes a plurality of substrates W on the placing portion 64 at a time. The transport mechanism 23 transports the plurality of substrates W from the first rear portion 6 to the bridge portion 4 at a time. A part of the transport mechanism 23 enters the second front portion 7. The support portion of the transport mechanism 23 enters the second front portion 7. The transport mechanism 23 takes a plurality of substrates W on the placing portion 74 at a time. The transport mechanism 23 transports the plurality of substrates W from the second front portion 7 to the bridge portion 4 at a time. A part of the transport mechanism 23 enters the second rear portion 8. The support portion of the transport mechanism 23 enters the second rear portion 8. The transport mechanism 23 takes a plurality of substrates W on the placing portion 84 at a time. The transport mechanism 23 transports the plurality of substrates W from the second rear portion 8 to the bridge portion 4 at a time.

For example, a part of the transport mechanism 24 enters the first front portion 5. The support portion 16 of the transport mechanism 24 enters the first front portion 5. The transport mechanism 24 takes a plurality of substrates W on the placing portion 54 at a time. The transport mechanism 24 transports the plurality of substrates W from the first front portion 5 to the bridge portion 4 at a time. Similarly, a part of the transport mechanism 24 enters the first rear portion 6. The support portion 16 of the transport mechanism 24 enters the first rear portion 6. The transport mechanism 24 takes a plurality of substrates W on the placing portion 64 at a time. The transport mechanism 24 transports the plurality of substrates W from the first rear portion 6 to the bridge portion 4 at a time. A part of the transport mechanism 24 enters the second front portion 7. The support portion 16 of the transport mechanism 24 enters the second front portion 7. The transport mechanism 24 takes a plurality of substrates W on the placing portion 74 at a time. The transport mechanism 24 transports the plurality of substrates W from the second front portion 7 to the bridge portion 4 at a time. A part of the transport mechanism 24 enters the second rear portion 8. The support portion 16 of the transport mechanism 24 enters the second rear portion 8. The transport mechanism 24 takes a plurality of substrates W on the placing portion 84 at a time. The transport mechanism 24 transports the plurality of substrates W from the second rear portion 8 to the bridge portion 4 at a time.

### Transport operation T17

The transport operation T17 corresponds to the above-described "discharge".

The transport mechanism 23 transports the plurality of substrates W from the bridge portion 4 to the slider portion 3 at a time. A part of the transport mechanism 23 enters the slider portion 3. The support portion of the transport mechanism 23 enters the slider portion 3. The transport mechanism 23 places the plurality of substrates W on the transport mechanism 41 at a time (transport operation T17).

For example, the transport mechanism 24 transports the plurality of substrates W from the bridge portion 4 to the slider portion 3 at a time. A part of the transport mechanism 24 enters the slider portion 3. The support portion 16 of the transport mechanism 24 enters the slider portion 3. The transport mechanism 24 places the plurality of substrates W on the transport mechanism 41 at a time (transport operation T17).

By the transport operations T16a and T17, the transport mechanism 24 transports the plurality of substrates W from the placing portion 54 to the transport mechanism 41 at a time. By the transport operations T16b and T17, the transport mechanism 24 transports the plurality of substrates W from the placing portion 64 to the transport mechanism 41 at a time. By the transport operations T16c and T17, the transport mechanism 24 transports the plurality of substrates W from the placing portion 74 to the transport mechanism 41 at a time. By the transport operations T16d and T17, the transport mechanism 24 transports the plurality of substrates W from the placing portion 84 to the transport mechanism 41 at a time.

### Transport operation T18

The transport mechanism 41 transports the plurality of substrates W from the second position P2 to the first position P1 at a time. As a result, the transport mechanism 41 transports the plurality of substrates W from the bridge portion 4 to the indexer portion 2 at a time. In other words, the transport mechanism 41 transports the plurality of substrates W from the transport mechanism 24 to the transport mechanism 12 at a time.

### Transport operation T19

The transport mechanism 12 takes the plurality of substrates W on the transport mechanism 41 at a time. The transport mechanism 12 transports the plurality of substrates W from the slider portion 3 to the indexer portion 2 at a time.

### Transport operation T20

The transport mechanism 12 places the plurality of substrates W in the carrier C on the carrier stage 11 at a time.

By the transport operations T19 and T20, the transport mechanism 12 transports the plurality of substrates W from the transport mechanism 41 to the carrier C at a time.

The transport operations T1 to T20 are referred to as transport operations T when not distinguished from one another. The number of transport operations T of the substrate processing apparatus 1 is, for example, 20. The number of transport operations T of the transport mechanism 12 is four. The number of transport operations T of the transport mechanism 41 is two. The number of transport operations T of the transport mechanism 23 is 14. The number of transport operations T of the transport mechanism 24 is eight. The number of transport operations T of the transport mechanism 25 is three. The number of transport operations T of the transport mechanism 26 is three. The number of transport operations T of the transport mechanism 55 is eight. The number of transport operations T of the transport mechanism 65 is eight. The number of transport operations T of the transport mechanism 75 is eight. The number of transport operations T of the transport mechanism 85 is eight.

The transport step T2 is an example of a first step of the present invention. The transport steps T3 and T4 are an example of a second step of the present invention.

The transport steps T5a, T6a, and T7a are an example of a third step of the present invention. The transport steps T5a, T6a, and T7b are an example of a fourth step of the present invention.

The transport step T7a is an example of a front placement step of the present invention. The transport step T7b is an example of a rear placement step of the present invention.

The transport steps T8a to T15a are an example of a front transport step of the present invention. The transport steps T8b to T15b are an example of a rear transport step of the present invention.

The transport step T16a is an example of a front acquisition step of the present invention. The transport step T16b is an example of a rear acquisition step of the present invention.

The transport step T16a is an example of a fifth step of the present invention. The transport step T16b is an example of a sixth step of the present invention. The transport step T17 is an example of a seventh step of the present invention. The transport steps T18 and T19 are an example of an eighth step of the present invention.

### <9. Effects of embodiment>

The substrate processing apparatus 1 includes the indexer portion 2, the slider portion 3, the bridge portion 4, the first front portion 5, and the first rear portion 6. The indexer portion 2, the slider portion 3, and the bridge portion 4 are arranged in this order in the front-rear direction X. The first front portion 5, the bridge portion 4, and the first rear portion 6 are arranged in this order in the front-rear direction X. The slider portion 3 transports the substrate W between the indexer portion 2 and the bridge portion 4. The bridge portion 4 transports the substrate W between the slider portion 3 and the first front portion 5. The bridge portion 4 transports the substrate W between the slider portion 3 and the first rear portion 6. The first front portion 5 includes the plurality of processing units 50. The first front portion 5 includes the transport mechanism 55. The transport mechanism 55 transports the substrate W to the processing unit 50. The first rear portion 6 includes the plurality of processing units 60. The first rear portion 6 includes the transport mechanism 65. The transport mechanism 65 transports the substrate W to the processing unit 60.

Here, the slider portion 3 overlaps with the processing unit 50 in plan view. Therefore, it is easy to arrange the processing units 50 and the transport mechanism 55 at high density. Thus, it is easy to improve throughput of the first front portion 5. That is, it is easy to efficiently process the substrate W in the first front portion 5.

In summary, according to the substrate processing apparatus 1, it is easy to improve throughput.

The slider portion 3 does not overlap with the transport mechanism 55 in plan view. Therefore, it is easy to arrange the processing units 50 and the transport mechanism 55 at high density. Thus, it is easy to improve throughput of the first front portion 5.

The slider portion 3 does not overlap with the first rear portion 6 in plan view. Therefore, it is easy to arrange the processing units 60 and the transport mechanism 65 at high density. Thus, it is easy to improve throughput of the first rear portion 6.

When the substrate W is transported from the indexer portion 2 to the first front portion 5, the substrate W always passes through the slider portion 3 and the bridge portion 4. When the substrate W is transported from the first front portion 5 to the indexer portion 2, the substrate W always passes through the slider portion 3 and the bridge portion 4. Therefore, the substrate W is efficiently transported between the indexer portion 2 and the first front portion 5. Thus, it is easy to improve throughput of the substrate processing apparatus 1.

When the substrate W is transported from the indexer portion 2 to the first rear portion 6, the substrate W always passes through the slider portion 3 and the bridge portion 4. When the substrate W is transported from the first rear portion 6 to the indexer portion 2, the substrate W always passes through the slider portion 3 and the bridge portion 4. Therefore, the substrate W is efficiently transported between the indexer portion 2 and the first rear portion 6. Thus, it is easy to improve throughput of the substrate processing apparatus 1.

The transport mechanism 55 is configured to move to a height position same as a height position of the slider portion 3. Therefore, it is easy to expand a movable range of the transport mechanism 55 in the vertical direction Z. Thus, it is easy to improve throughput of the first front portion 5.

The processing unit 50 includes the first processing unit 51. The first processing unit 51 and the slider portion 3 are arranged in the vertical direction Z. Therefore, it is easy for the slider portion 3 to overlap with the processing unit 50 in plan view.

The processing unit 50 includes the plurality of second processing units 52. The second processing units 52 are arranged in the vertical direction Z. At least one of the second processing units 52 is disposed at a height position same as a height position of the slider portion 3. Therefore, the processing units 50 and the transport mechanism 55 are arranged at high density. Furthermore, it is easy to increase the number of the second processing units 52. Thus, it is easy to improve throughput of the first front portion 5.

The first processing unit 51, the transport mechanism 55, and the second processing units 52 are arranged in this order in the width direction Y. Therefore, the transport mechanism 55 efficiently transports the substrate W to the first processing unit 51. The transport mechanism 55 efficiently transports the substrate W to the second processing unit 52. Thus, it is easy to improve throughput of the first front portion 5.

The first processing unit 51 performs non-liquid processing on the substrate W. The second processing unit 52 performs liquid processing on the substrate W. Therefore, it is easy to perform non-liquid processing and liquid processing on the substrate W in the first front portion 5.

The processing unit 50 includes the third processing unit 53. Therefore, it is easy to increase the number of the processing units 50.

The third processing unit 53 and the transport mechanism 55 are arranged in the front-rear direction X. Therefore, the transport mechanism 55 efficiently transports the substrate W to the third processing unit 53.

The substrate processing apparatus 1 includes the second front portion 7. The second front portion 7 includes the plurality of processing units 70. The second front portion 7 includes the transport mechanism 75. The transport mechanism 75 transports the substrate W to the processing unit 70. Therefore, it is easy to improve throughput of the substrate processing apparatus 1.

The slider portion 3 overlaps with the processing unit 70 in plan view. Therefore, it is easy to arrange the processing units 70 and the transport mechanism 75 at high density. Thus, it is easy to improve throughput of the second front portion 7.

The slider portion 3 is disposed between the first front portion 5 and the second front portion 7. Therefore, the slider portion 3 and the first front portion 5 are adjacent to each other. The slider portion 3 and the second front portion 7 are adjacent to each other. Thus, it is easy for the bridge portion 4 to transport the substrate W between the slider portion 3 and the first front portion 5. It is easy for the bridge portion 4 to transport the substrate W between the slider portion 3 and the second front portion 7.

The slider portion 3 does not overlap with the transport mechanism 75 in plan view. Therefore, it is easy to arrange the processing units 70 and the transport mechanism 75 at high density. Thus, it is easy to improve throughput of the second front portion 7.

The slider portion 3 has the lower portion 3a. The transport mechanism 55 is configured to move to a height position same as a height position of the lower portion 3a. Therefore, it is easy to expand a movable range of the transport mechanism 55 in the vertical direction Z. Thus, it is easy to improve throughput of the first front portion 5.

The slider portion 3 has the upper portion 3b. The upper portion 3b is located upward of the lower portion 3a. The transport mechanism 75 is configured to move to a height position same as a height position of the upper portion 3b. Therefore, it is easy to expand a movable range of the transport mechanism 75 in the vertical direction Z. Thus, it is easy to improve throughput of the second front portion 7.

The processing units 70 include the first processing unit 71. The first processing unit 71 is disposed upward of the first processing unit 51. The slider portion 3 is disposed upward of the first processing unit 51 and downward of the first processing unit 71. Therefore, it is easy for the slider portion 3 to overlap with the processing unit 50 in plan view. It is easy for the slider portion 3 to overlap with the processing unit 70 in plan view. It is easy to dispose the slider portion 3 between the first front portion 5 and the second front portion 7.

At least one of the second processing units 52 is disposed at a height position same as a height position of the lower portion 3a of the slider portion 3. Therefore, it is easy to dispose at least one of the second processing units 52 at a height position same as a height position of the slider portion 3.

The processing units 70 include the plurality of second processing units 72. The second processing units 72 are arranged in the vertical direction Z. At least one of the second processing units 72 is disposed at a height position same as a height position of the slider portion 3. Therefore, the processing units 70 and the transport mechanism 75 are arranged at high density. Furthermore, it is easy to increase the number of the second processing units 72. Thus, it is easy to improve throughput of the second front portion 7.

The indexer portion 2 includes the transport mechanism 12. The slider portion 3 includes the transport mechanism 41. The bridge portion 4 includes the transport mechanism 23. The transport mechanism 12 and the transport mechanism 41 deliver the substrate W to each other. The transport mechanism 41 and the transport mechanism 23 deliver the substrate W to each other. Therefore, it is easy for the slider portion 3 to transport the substrate W between the indexer portion 2 and the bridge portion 4.

The transport mechanism 12 includes the support portion 16. The transport mechanism 41 includes the support portion 43. The transport mechanism 23 includes the support portion. Therefore, it is easy for the transport mechanism 12 and the transport mechanism 41 to deliver the substrate W to each other. It is easy for the transport mechanism 41 and the transport mechanism 23 to deliver the substrate W to each other.

For example, the transport mechanism 24 includes the support portion 16. Therefore, it is easy for the transport mechanism 41 and the transport mechanism 24 to deliver the substrate W to each other.

When the transport mechanism 12 and the transport mechanism 41 deliver the substrate W to each other, the support portion 43 overlaps with the processing unit 50 in plan view. Therefore, the transport distance L is short. Thus, the slider portion 3 efficiently transports the substrate W between the indexer portion 2 and the bridge portion 4.

When the transport mechanism 41 and the transport mechanism 23 deliver the substrate W to each other, the support portion 43 overlaps with the processing unit 50 in plan view. Therefore, the transport distance L is short. Thus, the slider portion 3 efficiently transports the substrate W between the indexer portion 2 and the bridge portion 4.

The transport mechanism 12 and the transport mechanism 41 deliver a plurality of substrates W to each other at a time. Therefore, the transport mechanism 12 and the transport mechanism 41 efficiently deliver the substrate W to each other.

The transport mechanism 41 and the transport mechanism 23 deliver a plurality of substrates W to each other at a time. Therefore, the transport mechanism 41 and the transport mechanism 23 efficiently deliver the substrate W to each other.

The support portion 16 of the transport mechanism 12 includes the plurality of hands 18. Each of the hands 18 of the transport mechanism 12 supports one substrate W. The support portion 43 includes the plurality of hands 45. Each of the hands 45 supports one substrate W. The support portion of the transport mechanism 23 includes the plurality of hands. Each of the hands of the transport mechanism 23 supports one substrate W. Therefore, it is easy for the transport mechanism 12 and the transport mechanism 41 to deliver the plurality of substrates W to each other at a time. It is easy for the transport mechanism 41 and the transport mechanism 23 to deliver a plurality of substrates W to each other at a time.

For example, the support portion 16 of the transport mechanism 24 includes the plurality of hands 18. Each of the hands 18 of the transport mechanism 24 supports one substrate W. Therefore, it is easy for the transport mechanism 41 and the transport mechanism 24 to deliver the plurality of substrates W to each other at a time.

The substrate processing method according to the embodiment includes the first step, the second step, the third step, the fourth step, the front transport step, and the rear transport step. The first step is the transport step T2. In the first step, the substrate W is transported from the indexer portion 2 to the slider portion 3. The second step is the transport steps T3 and T4. In the second step, the substrate W is transported from the slider portion 3 to the bridge portion 4. The third step is the transport steps T5a, T6a, and T7a. In the third step, the substrate W is transported from the bridge portion 4 to the first front portion 5. The fourth step is the transport steps T5a, T6a, and T7b. In the fourth step, the substrate W is transported from the bridge portion 4 to the first rear portion 6. The front transport step is the transport steps T8a to T15a. In the front transport step, the transport mechanism 55 of the first front portion 5 transports the substrate W to the processing unit 50 of the first front portion 5. The rear transport step is the transport steps T8b to T15b. In the rear transport step, the transport mechanism 65 of the first rear portion 6 transports the substrate W to the processing unit 60 of the first rear portion 6.

Here, the processing unit 50 of the first front portion 5 overlaps with the slider portion 3 in plan view. Therefore, it is easy to arrange the processing unit 50 and the transport mechanism 55 at high density. Thus, it is easy to improve throughput of the first front portion 5. That is, it is easy to efficiently process the substrate W in the first front portion 5.

When the substrate W is transported from the indexer portion 2 to the first front portion 5, the first step, the second step, and the third step are executed. When the substrate W is transported from the indexer portion 2 to the first front portion 5, the transport steps T2, T3, T4, T5a, T6a, and T7a are executed. Therefore, the substrate W is efficiently transported from the indexer portion 2 to the first front portion 5. Thus, it is easy to improve throughput of the first front portion 5.

When the substrate W is transported from the indexer portion 2 to the first rear portion 6, the first step, the second step, and the fourth step are executed. When the substrate W is transported from the indexer portion 2 to the first rear portion 6, the transport steps T2, T3, T4, T5a, T6a, and T7b are executed. Therefore, the substrate W is efficiently transported from the indexer portion 2 to the first rear portion 6. Thus, it is easy to improve throughput of the first rear portion 6.

In summary, according to the substrate processing method of the embodiment, it is easy to improve throughput.

The slider portion 3 does not overlap with the transport mechanism 55 in plan view. Therefore, it is easy to arrange the processing unit 50 and the transport mechanism 55 at high density. Thus, it is easy to improve throughput of the first front portion 5.

The substrate processing method includes the fifth step, the sixth step, the seventh step, and the eighth step. The fifth step is the transport step T16a. In the fifth step, the substrate W is transported from the first front portion 5 to the bridge portion 4. The sixth step is the transport step T16b. In the sixth step, the substrate W is transported from the first rear portion 6 to the bridge portion 4. The seventh step is the transport step T17. In the seventh step, the substrate W is transported from the bridge portion 4 to the slider portion 3. The eighth step is the transport steps T18 and T19. In the eighth step, the substrate W is transported from the slider portion 3 to the indexer portion 2.

Here, when the substrate W is transported from the first front portion 5 to the indexer portion 2, the fifth step, the seventh step, and the eighth step are executed. When the substrate W is transported from the first front portion 5 to the indexer portion 2, the transport steps T16a, T17, T18, and T19 are executed. Therefore, the substrate W is efficiently transported from the first front portion 5 to the indexer portion 2. Thus, it is easy to improve throughput of the first front portion 5.

When the substrate W is transported from the first rear portion 6 to the indexer portion 2, the sixth step, the seventh step, and the eighth step are executed. When the substrate W is transported from the first rear portion 6 to the indexer portion 2, the transport steps T16b, T17, T18, and T19 are executed. Therefore, the substrate W is efficiently transported from the first rear portion 6 to the indexer portion 2. Thus, it is easy to improve throughput of the first rear portion 6.

In summary, according to the substrate processing method, it is easy to improve throughput.

### <10. Modified embodiment>

The present invention is not limited to the embodiment, and can be modified as follows.
(1) The transport mechanism 25 may perform "distribution" related to the second front portion 7 and the second rear portion 8, in addition to "distribution" related to the first front portion 5 and the first rear portion 6.

**In** the modified embodiment of (1) described above, the transport mechanism 26 may be omitted. The configuration of the bridge portion 4 is simplified.

(2) The transport mechanisms 25 and 26 may perform at least one of "take-in" or "discharge" in addition to "distribution". Hereinafter, three modified embodiments will be described.

(2-1) The transport mechanisms 25 and 26 take the substrate W in the slider portion 3. The transport mechanism 24 places the substrate W in the slider portion 3.

According to the modified embodiment of (2-1) described above, it is easy for the bridge portion 4 to take the substrate W in the slider portion 3. It is easy for the bridge portion 4 to place the substrate W in the slider portion 3.

(2-2) The transport mechanisms 25 and 26 place the substrate W in the slider portion 3. The transport mechanism 24 takes the substrate W in the slider portion 3.

According to the modified embodiment of (2-2) described above, it is easy for the bridge portion 4 to take the substrate W in the slider portion 3. It is easy for the bridge portion 4 to place the substrate W in the slider portion 3.

(2-3) The transport mechanisms 25 and 26 take the substrate W in the slider portion 3, and place the substrate W in the slider portion 3.

According to the modified embodiment of (2-3) described above, it is easy for the bridge portion 4 to take the substrate W in the slider portion 3. It is easy for the bridge portion 4 to place the substrate W in the slider portion 3.

(3) The transport mechanisms 25 and 26 may perform "collection" in addition to "distribution".

For example, the transport mechanism 25 takes the substrate W in the first front portion 5. That is, the transport mechanism 25 performs the transport operation T16a. Therefore, the number of the transport operations T of the transport mechanism 55 is small. For example, the transport mechanism 55 does not perform the transport operation T16a. Thus, it is easy to improve throughput of the first front portion 5.

For example, the transport mechanism 25 takes the substrate W in the first rear portion 6. Therefore, the number of the transport operations T of the transport mechanism 65 is small. Thus, it is easy to improve throughput of the first rear portion 6.

For example, the transport mechanism 26 takes the substrate W in the second front portion 7. Therefore, the number of the transport operations T of the transport mechanism 75 is small. Thus, it is easy to improve throughput of the second front portion 7.

For example, the transport mechanism 26 takes the substrate W in the second rear portion 8. Therefore, the number of the transport operations T of the transport mechanism 85 is small. Thus, it is easy to improve throughput of the second rear portion 8.

(4) The transport mechanisms 25 and 26 may perform "collection", "take-in", and "discharge" in addition to "distribution".

**In** the modified embodiment of (4) described above, the transport mechanism 24 may be omitted. The configuration of the bridge portion 4 is simplified.

(5) The transport mechanism 24 may perform "distribution" in addition to "collection", "take-in", and "discharge".

Specifically, the transport mechanism 24 places the substrate W in the first front portion 5. That is, the transport mechanism 24 performs the transport operations T6a and T7a. Therefore, the number of the transport operations T of the transport mechanism 55 is small. For example, the transport mechanism 55 does not perform the transport operations T6a and T7a. Thus, it is easy to improve throughput of the first front portion 5.

The transport mechanism 24 places the substrate W in the first rear portion 6. Therefore, the number of the transport operations T of the transport mechanism 65 is small. Thus, it is easy to improve throughput of the first rear portion 6.

The transport mechanism 24 places the substrate W in the second front portion 7. Therefore, the number of the transport operations T of the transport mechanism 75 is small. Thus, it is easy to improve throughput of the second front portion 7.

The transport mechanism 24 places the substrate W in the second rear portion 8. Therefore, the number of the transport operations T of the transport mechanism 85 is small. Thus, it is easy to improve throughput of the second rear portion 8.

**In** the modified embodiment of (5) described above, the transport mechanisms 25 and 26 may be omitted. The configuration of the bridge portion 4 is simplified.

**In** the modified embodiment of (5) described above, the transport mechanism 24 is an example of the first distribution mechanism of the present invention. The transport mechanism 24 is also an example of the second distribution mechanism of the present invention.

(6) The "collection" may be performed by two transport mechanisms.

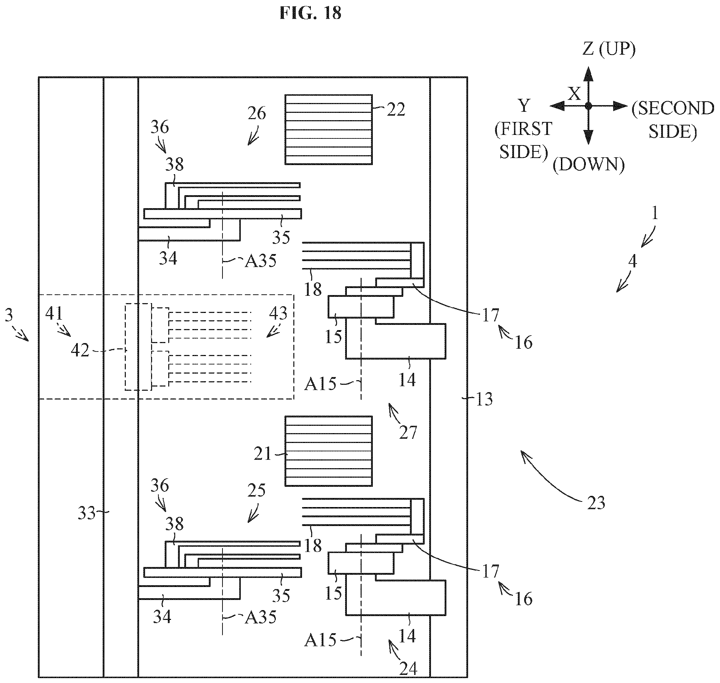

FIG. 18 is a front view of the bridge portion 4 according to a modified embodiment. The same components as those of the embodiment are denoted by the same reference numerals, and a detailed description thereof will be omitted.

The bridge portion 4 further includes a transport mechanism 27. The transport mechanism 27 is disposed upward of the transport mechanism 24. The transport mechanism 27 has the same structure as the transport mechanism 24.

For example, the transport mechanism 24 takes the substrate W in the first front portion 5 and takes the substrate W in the first rear portion 6. That is, the transport mechanism 24 performs the transport operations T16a and T16b.

For example, the transport mechanism 27 takes the substrate W in the second front portion 7 and takes the substrate W in the second rear portion 8. That is, the transport mechanism 27 performs the transport operations T16c and T16d.

According to the modified embodiment of (6) described above as well, the number of the transport operations T of the transport mechanism 55 is small, and the number of the transport operations T of the transport mechanism 65 is small. Therefore, it is easy to improve throughput of the first front portion 5 and the first rear portion 6. According to the modified embodiment of (6) described above as well, the number of the transport operations T of the transport mechanism 75 is small, and the number of the transport operations T of the transport mechanism 85 is small. Therefore, it is easy to improve throughput of the second front portion 7 and the second rear portion 8.

The transport mechanism 27 is an example of a second collection mechanism of the present invention.

(7) The transport mechanism 25 may place the substrate W on the placing portion 54. Therefore, it is easy for the transport mechanism 25 to place the substrate W in the first front portion 5. Furthermore, the number of the transport operations T of the transport mechanism 55 is small. For example, the transport mechanism 55 does not perform the transport operation T6a. The transport mechanism 55 does not perform the transport operation T7a. Thus, it is easy to improve throughput of the first front portion 5.

Similarly, the transport mechanism 25 may place the substrate W on the placing portion 64. Therefore, it is easy for the transport mechanism 25 to place the substrate W in the first rear portion 6. Furthermore, the number of the transport operations T of the transport mechanism 65 is small. For example, the transport mechanism 65 does not perform the transport operation T6a. The transport mechanism 65 does not perform the transport operation T7b. Thus, it is easy to improve throughput of the first rear portion 6.

(8) The transport mechanism 26 may place the substrate W on the placing portion 74. Therefore, it is easy for the transport mechanism 26 to place the substrate W in the second front portion 7. Furthermore, the number of the transport operations T of the transport mechanism 75 is small. For example, the transport mechanism 75 does not perform the transport operation T6b. The transport mechanism 75 does not perform the transport operation T7c. Thus, it is easy to improve throughput of the second front portion 7.

Similarly, the transport mechanism 26 may place the substrate W on the placing portion 84. Therefore, it is easy for the transport mechanism 26 to place the substrate W in the second rear portion 8. Furthermore, the number of the transport operations T of the transport mechanism 85 is small. For example, the transport mechanism 85 does not perform the transport operation T6b. The transport mechanism 85 does not perform the transport operation T7d. Thus, it is easy to improve throughput of the second rear portion 8.

(9) The transport mechanism 24 may take the substrate W in the processing unit 50. For example, the transport mechanism 24 may take the substrate W in the first processing unit 51. Therefore, it is easy for the transport mechanism 24 to take the substrate W in the first front portion 5. Furthermore, the number of the transport operations T of the transport mechanism 55 is small. For example, the transport mechanism 55 does not perform the transport operations T14a and T15a. The transport mechanism 55 does not perform the transport operation T16a. Thus, it is easy to improve throughput of the first front portion 5.

The first processing unit 51 preferably includes a processing unit 50 that performs processing last in the first front portion 5. If the cooling unit CP is the processing unit 50 that performs processing last in the first front portion 5, at least some of the processing units 51 are preferably classified as the cooling unit CP. Therefore, it is easy for the transport mechanism 24 to take the substrate W in the processing unit 50.

Similarly, the transport mechanism 24 may take the substrate W in the processing unit 60. For example, the transport mechanism 24 may take the substrate W in the first processing unit 61. Therefore, it is easy for the transport mechanism 24 to take the substrate W in the first rear portion 6. Furthermore, the number of the transport operations T of the transport mechanism 65 is small. For example, the transport mechanism 65 does not perform the transport operations T14b and T15b. The transport mechanism 65 does not perform the transport operation T16b. Thus, it is easy to improve throughput of the first rear portion 6.

The transport mechanism 24 may take the substrate W in the processing unit 70. For example, the transport mechanism 24 may take the substrate W in the first processing unit 71. Therefore, it is easy for the transport mechanism 24 to take the substrate W in the second front portion 7. Furthermore, the number of the transport operations T of the transport mechanism 75 is small. For example, the transport mechanism 75 does not perform the transport operations T14c and T15c. The transport mechanism 75 does not perform the transport operation T16c. Thus, it is easy to improve throughput of the second front portion 7.

The transport mechanism 24 may take the substrate W in the processing unit 80. For example, the transport mechanism 24 may take the substrate W in the first processing unit 81. Therefore, it is easy for the transport mechanism 24 to take the substrate W in the second rear portion 8. Furthermore, the number of the transport operations T of the transport mechanism 85 is small. For example, the transport mechanism 85 does not perform the transport operations T14d and T15d. The transport mechanism 85 does not perform the transport operation T16d. Thus, it is easy to improve throughput of the second rear portion 8.

(10) The second front portion 7 may be omitted.

(11) The second rear portion 8 may be omitted.

(12) A shape of the guide 42 may be appropriately changed.

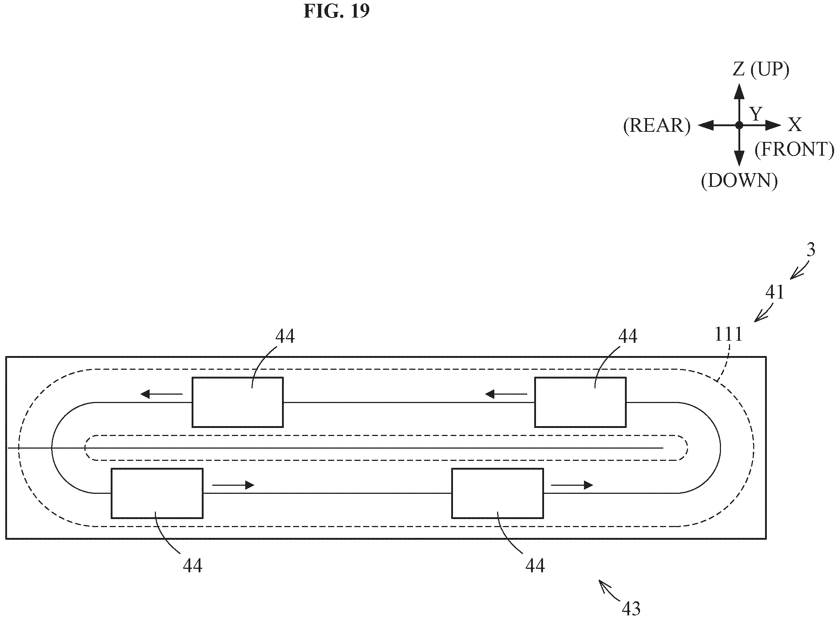

FIG. 19 is a side view of the slider portion 3 according to a modified embodiment. The same components as those of the embodiment are denoted by the same reference numerals, and a detailed description thereof will be omitted.

The transport mechanism 41 includes a guide 111. In FIG. 19, the guide 111 is indicated by a broken line. The guide 111 has a closed curved shape. The guide 111 has, for example, an elliptical shape. The guide 111 has a rounded rectangle shape.

The support portion 43 circularly moves along the guide 111. The support portion 43 includes, for example, a plurality of movable elements 44. In FIG. 19, the movable elements 44 are indicated by solid lines. Each movable element 44 circulates around along the guide 111. Each movable element 44 supports the hand 45 (not illustrated).

An effect of the modified embodiment of (12) described above will be described. The slider portion 3 efficiently transports the substrate W between the indexer portion 2 and the bridge portion 4.

It is easy to increase the number of the movable elements 44. Even when the slider portion 3 is narrow, it is easy to increase the number of the movable elements 44. In other words, even when an installation space for the slider portion 3 is small, it is easy to increase the number of the movable elements 44. Thus, it is easy to increase the number of hands 45. Therefore, even when the slider portion 3 is small, the slider portion 3 efficiently transports the substrate W. In other words, it is easy to reduce the size of the slider portion 3.

(13) The slider portion 3 may further detect the substrate W.

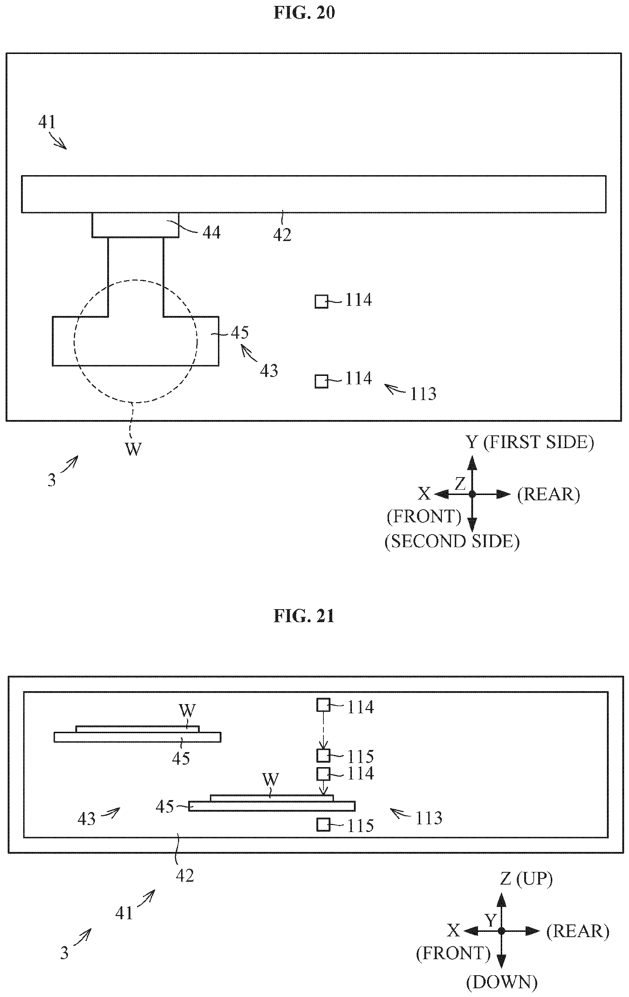

FIG. 20 is a plan view of the slider portion 3 according to a modified embodiment. FIG. 21 is a side view of the slider portion 3 according to the modified embodiment. FIGS. 20 and 21 illustrate the transport mechanism 41 simply for convenience. The same components as those of the embodiment are denoted by the same reference numerals, and a detailed description thereof will be omitted.

The slider portion 3 includes a detector 113. The detector 113 detects the substrate W supported by the support portion 43. The detector 113 detects a position of the substrate W supported by the support portion 43. The detector 113 detects the substrate W supported by the support portion 43 without coming into contact with the substrate W supported by the support portion 43.

The detector 113 is an example of a substrate position sensor of the present invention.

The detector 113 may individually detect each substrate W supported by the support portion 43. The detector 113 may collectively detect a plurality of substrates W supported by the support portion 43.

For example, the detector 113 includes at least one of a photoelectric sensor or an imaging unit. For example, the photoelectric sensor may be classified as a transmission type. Alternatively, the photoelectric sensor may be classified as a reflection type. The imaging unit images the substrate W to acquire an image of the substrate W. The image may be a one-dimensional image. The image may be a two-dimensional image. The imaging unit includes, for example, at least one of a camera or a line sensor.

For example, the detector 113 includes a plurality of light projectors 114 and a plurality of light receivers 115. The light projector 114 and the light receiver 115 are disposed to face each other. For example, the light projector 114 is disposed upward of the substrate W supported by the support portion 43. For example, the light receiver 115 is disposed downward of the substrate W supported by the support portion 43. The light projector 114 emits light toward the light receiver 115. The light receiver 115 receives light of the light projector 114.

When the substrate W is not located between the light projector 114 and the light receiver 115, the substrate W does not block light of the light projector 114, and the light receiver 115 receives light of the light projector 114. When the light receiver 115 receives light of the light projector 114, the detector 113 detects that the substrate W is not present between the light projector 114 and the light receiver 115.

When the substrate W is located between the light projector 114 and the light receiver 115, the substrate W blocks light of the light projector 114, and the light receiver 115 does not receive light of the light projector 114. When the light receiver 115 does not receive light of the light projector 114, the detector 113 detects that the substrate W is present between the light projector 114 and the light receiver 115.

For example, the detector 113 is unmovable. The detector 113 is fixedly installed. When the transport mechanism 41 transports the substrate W, the detector 113 detects the substrate W supported by the support portion 43.

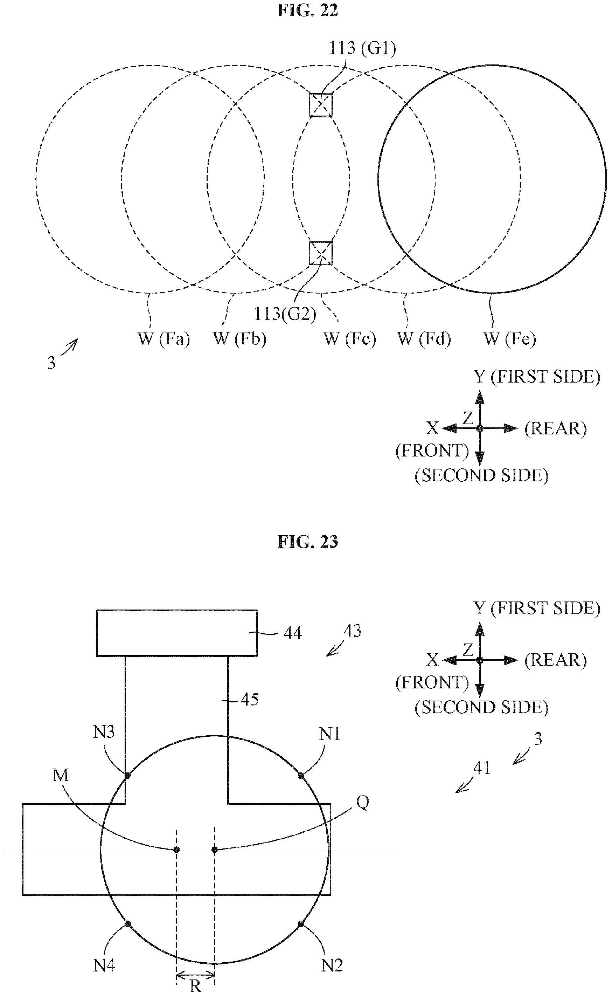

FIG. 22 is the plan view of the slider portion 3 according to a modified embodiment. In FIG. 22, illustration of the transport mechanism 41 is omitted for convenience. The same components as those of the embodiment are denoted by the same reference numerals, and a detailed description thereof will be omitted.

The substrate W is moved between positions Fa, Fb, Fc, Fd, and Fe by the transport mechanism 41. When the substrate W moves between the position Fa and the position Fb, the detector 113 does not detect the substrate W. When the substrate W moves between the position Fb, the position Fc, and the position Fd, the detector 113 detects the substrate W. When the substrate W moves between the position Fd and the position Fe, the detector 113 does not detect the substrate W.

The detector 113 detects the substrate W moving between the position Fb and the position Fd. The detector 113 detects a timing at which the substrate W moves between the position Fb and the position Fd. The detector 113 monitors the substrate W moving between the position Fb and the position Fd.

The detector 113 outputs a detection result of the detector 113 to the controller 10 described above.

The controller 10 acquires the detection result of the detector 113. The controller 10 may acquire a position of the substrate W with respect to the support portion 43 on the basis of the detection result of the detector 113.

A procedure for acquiring the position of the substrate W with respect to the support portion 43 will be described.

The detector 113 is disposed at positions G1 and G2. The positions G1 and G2 are known.

The controller 10 acquires times H1 and H2 (not illustrated) on the basis of the detection result of the detector 113. The times H1 and H2 are times at which the detector 113 detects a peripheral edge of the substrate W. For example, at the time H1, the substrate W is located at the position Fb. At the time H2, the substrate W is located at the position Fd.

The controller 10 acquires positions J1 and J2 (not illustrated) on the basis of the times H1 and H2. For example, the position J1 is a position of a center of the hand 45 at the time H1. The position J2 is a position of the center of the hand 45 at the time H2.

When acquiring the positions J1 and J2, the controller 10 may refer to a position of the hand 45. For example, the position of the hand 45 is given by a command input to the transport mechanism 41. For example, the position of the hand 45 is given by a detection result of a sensor that detects an operation amount of the transport mechanism 41. Therefore, when acquiring the positions J1 and J2, the controller 10 may refer to at least one of the command input to the transport mechanism 41 or the detection result of the sensor that detects an operation amount of the transport mechanism 41. The sensor is, for example, an encoder.

FIG. 23 is the plan view of the slider portion 3 according to a modified embodiment. The same components as those of the embodiment are denoted by the same reference numerals, and a detailed description thereof will be omitted.

The positions J1, G1, and G2 are individually translated in the front-rear direction X and the width direction Y. Then, the position J1 is shifted to a position M. Similarly, the positions G1 and G2 are shifted to the positions N1 and N2, respectively. A direction and an amount of movement from the position G1 to the position N1 are the same as a direction and an amount of movement from the position J1 to the position M. A direction and an amount of movement from the position G2 to the position N2 are the same as a direction and an amount of movement from the position J1 to the position M.

The positions J2, G1, and G2 are individually translated in the front-rear direction X and the width direction Y. Then, the position J2 is shifted to the position M. Similarly, the positions G1 and G2 are shifted to positions N3 and N4, respectively. A direction and an amount of movement from the position G1 to the position N3 are the same as a direction and an amount of movement from the position J2 to the position M. A direction and an amount of movement from the position G2 to the position N4 are the same as a direction and an amount of movement from the position J2 to the position M.

The position M corresponds to the position of the center of the hand 45. The position M is referred to as a "center M" for convenience.

The controller 10 acquires the positions N1 and N2 with respect to the center M on the basis of the position J1 and the positions G1 and G2. The controller 10 acquires the positions N3 and N4 with respect to the center M on the basis of the position J2 and the positions G1 and G2. Each of the positions N1 to N4 is a point on a peripheral edge of the substrate W.

The controller 10 acquires a position of a center Q of the substrate W with respect to the center M on the basis of the positions M and N1 to N4.

The position Q with respect to the position M corresponds to a position of the substrate W with respect to the support portion 43.

The controller 10 acquires a distance R between the center M and the center Q on the basis of the positions M and Q. When the center Q coincides with the center M, the distance R is zero. When the center Q does not coincide with the center M, the distance R is greater than zero.

When the distance R is short, the support portion 43 appropriately supports the substrate W. When the distance R is long, the support of the substrate W by the support portion 43 is not appropriate.

The distance R is an example of an index indicating a position of the substrate W with respect to the support portion 43.

The controller 10 may control at least one of the transport mechanisms 12, 41, and 23 on the basis of a detection result of the detector 113. For example, the controller 10 may control at least one of the transport mechanisms 12, 41, and 24 on the basis of the detection result of the detector 113.

For example, the controller 10 may adjust an operation amount of the transport mechanism 12 when the transport mechanism 12 takes the substrate W on the transport mechanism 41. Therefore, when the transport mechanism 12 takes the substrate W from the slider portion 3, it is easy to adjust a position of the substrate W with respect to the support portion 16 of the transport mechanism 12. Thus, it is easy to position the substrate W at a position appropriate for the support portion 16 of the transport mechanism 12 regardless of the position of the substrate W with respect to the support portion 43 of the slider portion 3.

For example, the controller 10 may adjust an operation amount of the transport mechanism 23 when the transport mechanism 23 takes the substrate W on the transport mechanism 41. Therefore, when the transport mechanism 23 takes the substrate W from the slider portion 3, it is easy to adjust a position of the substrate W with respect to the support portion of the transport mechanism 23. Thus, it is easy to position the substrate W at a position appropriate for the support portion of the transport mechanism 23 regardless of the position of the substrate W with respect to the support portion 43 of the slider portion 3.

For example, the controller 10 may adjust an operation amount of the transport mechanism 24 when the transport mechanism 24 takes the substrate W on the transport mechanism 41. Therefore, when the transport mechanism 24 takes the substrate W from the slider portion 3, it is easy to adjust a position of the substrate W with respect to the support portion 16 of the transport mechanism 24. Thus, it is easy to position the substrate W at a position appropriate for the support portion 16 of the transport mechanism 24 regardless of the position of the substrate W with respect to the support portion 43 of the slider portion 3.

For example, the controller 10 may change a moving speed of the transport mechanism 41. For example, the controller 10 may stop the transport mechanism 41.

For example, when the transport mechanism 12 places a new substrate W on the transport mechanism 41, the controller 10 may change an operation amount of the transport mechanism 12. For example, when the transport mechanism 12 places the new substrate W on the transport mechanism 41, the controller 10 may change the first position P1 of the support portion 43. Therefore, when the transport mechanism 12 places the substrate W in the slider portion 3, it is easy to position the new substrate W at a position appropriate for the support portion 43 of the slider portion 3.

For example, when the transport mechanism 23 places a new substrate W on the transport mechanism 41, the controller 10 may change an operation amount of the transport mechanism 23. For example, when the transport mechanism 23 places the new substrate W on the transport mechanism 41, the controller 10 may change the second position P2 of the support portion 43. Therefore, when the transport mechanism 23 places the substrate W in the slider portion 3, it is easy to position the new substrate W at a position appropriate for the support portion 43 of the slider portion 3.

For example, when the transport mechanism 24 places a new substrate W on the transport mechanism 41, the controller 10 may change an operation amount of the transport mechanism 24. For example, when the transport mechanism 24 places the new substrate W on the transport mechanism 41, the controller 10 may change the second position P2 of the support portion 43. Therefore, when the transport mechanism 24 places the substrate W in the slider portion 3, it is easy to position the new substrate W at a position appropriate for the support portion 43 of the slider portion 3.

An effect of the modified embodiment of (13) described above will be described. The slider portion 3 includes the detector 113. The detector 113 detects the substrate W supported by the support portion 43. Therefore, it is easy to monitor the transport of the substrate W in the slider portion 3.

The detector 113 is unmovable. Therefore, it is easy to install the detector 113.

When the transport mechanism 41 transports the substrate W, the detector 113 detects the substrate W supported by the support portion 43. When the transport mechanism 41 transports the substrate W, a relative position between the substrate W and the detector 113 changes. Therefore, even when the detector 113 is unmovable, it is easy for the detector 113 to detect the substrate W supported by the support portion 43.

The substrate processing apparatus 1 includes the controller 10. The controller 10 controls at least one of the transport mechanism 12, the transport mechanism 41, or the transport mechanism 23 on the basis of a detection result of the detector 113. Therefore, the support portion 43 appropriately supports the substrate W. Thus, the slider portion 3 appropriately transports the substrate W between the indexer portion 2 and the bridge portion 4.

For example, the controller 10 controls at least one of the transport mechanism 12, the transport mechanism 41, or the transport mechanism 24 on the basis of a detection result of the detector 113. Therefore, the support portion 43 appropriately supports the substrate W. Thus, the slider portion 3 appropriately transports the substrate W between the indexer portion 2 and the bridge portion 4.

(14) The slider portion 3 may further inspect the substrate W.

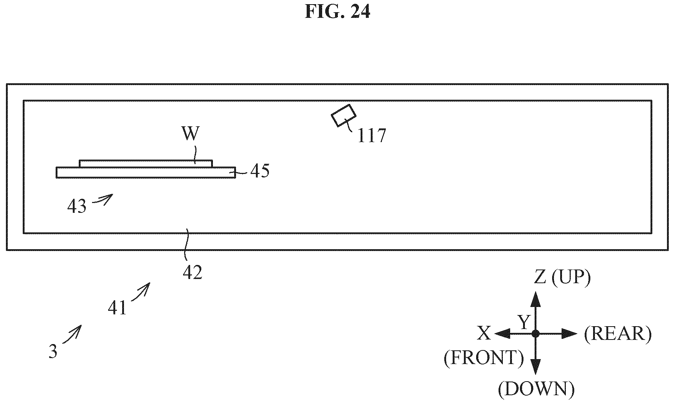

FIG. 24 is a side view of the slider portion 3 according to a modified embodiment. The same components as those of the embodiment are denoted by the same reference numerals, and a detailed description thereof will be omitted.

The slider portion 3 includes an inspection portion 117. The inspection portion 117 inspects the substrate W supported by the support portion 43. For example, the inspection by the inspection portion 117 includes at least one of measurement of a shape of a surface of the substrate W, identification of a state of the surface of the substrate W, or detection of a defect on the surface of the substrate W. The surface of the substrate W may include at least one of a pattern or a coating film. The measurement of the shape of the surface of the substrate W includes, for example, measurement of a film thickness of a coating film formed on the surface of the substrate W.

The inspection portion 117 images the surface of the substrate W, for example. The inspection portion 117 acquires, for example, an image of the surface of the substrate W. The image may be a one-dimensional image. The image may be a two-dimensional image.

For example, the inspection portion 117 includes an imaging unit. The imaging unit includes, for example, at least one of a camera or a line sensor.

For example, the inspection portion 117 is unmovable. The inspection portion 117 is fixedly installed. When the transport mechanism 41 transports the substrate W, the inspection portion 117 inspects the substrate W supported by the support portion 43.

An effect of the modified embodiment of (14) described above will be described. The slider portion 3 includes the inspection portion 117. The inspection portion 117 inspects the substrate W supported by the support portion 43. Therefore, the substrate processing apparatus 1 inspects the substrate W without increasing the number of the transport operations T of the substrate processing apparatus 1. Thus, it is easy to improve throughput of the substrate processing apparatus 1.

The inspection portion 117 is unmovable. Therefore, it is easy to install the inspection portion 117.

When the transport mechanism 41 transports the substrate W, the inspection portion 117 inspects the substrate W supported by the support portion 43. When the transport mechanism 41 transports the substrate W, a relative position between the substrate W and the inspection portion 117 changes. Therefore, even when the inspection portion 117 is unmovable, it is easy for the inspection portion 117 to inspect the substrate W supported by the support portion 43.

(15)In the embodiment and each modified embodiment described in (1) to (14) described above, each configuration may be appropriately changed by further replacing or combining each configuration with a configuration of another modified embodiment.

The present invention may be embodied in other specific forms without departing from the spirit or essential attributes thereof and, accordingly, reference should be made to the appended claims, rather than to the foregoing specification, as indicating the scope of the invention.

### Reference Signs List

1: Substrate processing apparatus
2: Indexer portion
3: Slider portion
4: Bridge portion
5: First front portion
6: First rear portion
7: Second front portion
8: Second rear portion
9: Cabinet portion
10: Controller
11: Carrier stage
C: Carrier
12: Transport mechanism (first transport mechanism)
16: Support portion (first support portion, third support portion)
18: Hand (first hand, third hand)
21: Placing portion (first intermediate placing portion)
22: Placing portion (second intermediate placing portion)
23: Transport mechanism (third transport mechanism)
24: Transport mechanism (first collection mechanism)
25: Transport mechanism (first distribution mechanism)
26: Transport mechanism (second distribution mechanism)
27: Transport mechanism (second collection mechanism)
36: Support portion (third support portion)
38: Hand (third hand)
41: Transport mechanism (second transport mechanism)
42: Guide
43: Support portion (second support portion)
45: Hand (second hand)
50: Processing unit (processing unit of first front portion)
51: First processing unit
52: Second processing unit
53: Third processing unit
54: Placing portion (first front placing portion)
55: Transport mechanism (first front transport mechanism)
60: Processing unit (processing unit of first rear portion)
61: First processing unit
62: Second processing unit
63: Third processing unit
64: Placing portion (first rear placing portion)
65: Transport mechanism (first rear transport mechanism)
70: Processing unit (processing unit of second front portion)
71: First processing unit
72: Second processing unit
73: Third processing unit
74: Placing portion (second front placing portion)
75: Transport mechanism (second front transport mechanism)
80: Processing unit (processing unit of second rear portion)
81: First processing unit
82: Second processing unit
83: Third processing unit
84: Placing portion (second rear placing portion)
85: Transport mechanism (second rear transport mechanism)
111: Guide
113: Detector (substrate position sensor)
117: Inspection portion
L: Transport distance of substrate in slider portion
K: Distance between indexer portion and bridge portion in front-rear direction
P1: First position
P2: Second position
T: Transport step
T2: Transport step (first step)
T3, T4: Transport step (second step)
T5a, T6a, T7a: Transport step (third step)
T7a: Transport step (front placement step)
T5a, T6a, T7b: Transport step (fourth step)
T7b: Transport step (rear placement step)
T8a-T15a: Transport step (front transport step)
T8b-T15b: Transport step (rear transport step)
T16a: Transport step (fifth step, front acquisition step)
T16b: Transport step (sixth step, rear acquisition step)
T17: Transport step (seventh step)
T18, T19: Transport step (eighth step)
W: Substrate
X: Front-rear direction (first direction)
Y: Width direction (second direction)
Z: Vertical direction

## Claims

1. A substrate processing apparatus comprising:
an indexer portion;
a slider portion;
a bridge portion;
a first front portion; and
a first rear portion,
wherein the indexer portion, the slider portion, and the bridge portion are arranged in this order in a first direction,
the first direction is horizontal,
the first front portion, the bridge portion, and the first rear portion are arranged in this order in the first direction,
the slider portion transports a substrate between the indexer portion and the bridge portion,
the bridge portion transports a substrate between the slider portion and the first front portion, and transports a substrate between the slider portion and the first rear portion,
the first front portion includes:
a plurality of processing units; and
a first front transport mechanism configured to transport a substrate to each of the processing units of the first front portion,
the first rear portion includes:
a plurality of processing units; and
a first rear transport mechanism configured to transport a substrate to each of the processing units of the first rear portion, and
the slider portion overlaps with the processing units of the first front portion in plan view.

2. The substrate processing apparatus according to claim 1, wherein
the slider portion does not overlap with the first rear portion in plan view.

3. The substrate processing apparatus according to claim 1, wherein
a substrate always passes through the slider portion and the bridge portion when a substrate is transported from the indexer portion to the first front portion, and
a substrate always passes through the slider portion and the bridge portion when a substrate is transported from the first front portion to the indexer portion.

4. The substrate processing apparatus according to claim 1, wherein
a substrate always passes through the slider portion and the bridge portion when a substrate is transported from the indexer portion to the first rear portion, and
a substrate always passes through the slider portion and the bridge portion when a substrate is transported from the first rear portion to the indexer portion.

5. The substrate processing apparatus according to claim 1, wherein
the first front transport mechanism is configured to move to a height position same as a height position of the slider portion.

6. The substrate processing apparatus according to claim 1, wherein
the processing units of the first front portion include:
a first processing unit; and
a plurality of second processing units,
the first processing unit of the first front portion and the slider portion are arranged in a vertical direction,
the second processing units of the first front portion are arranged in a vertical direction, and
at least one of the second processing units of the first front portion is disposed at a height position same as a height position of the slider portion.

7. The substrate processing apparatus according to claim 6, wherein
the first processing unit of the first front portion, the first front transport mechanism, and the second processing units of the first front portion are arranged in this order in a second direction, and
the second direction is horizontal and is orthogonal to the first direction.

8. The substrate processing apparatus according to claim 6, wherein
the first processing unit of the first front portion performs non-liquid processing on a substrate, and
each of the second processing units of the first front portion performs liquid processing on a substrate.

9. The substrate processing apparatus according to claim 6, wherein
the processing units of the first front portion include a third processing unit, and the third processing unit of the first front portion and the first front transport mechanism are arranged in the first direction.

10. The substrate processing apparatus according to claim 6, comprising:
a second front portion disposed upward of the first front portion, wherein
the second front portion includes:
a plurality of processing units; and
a second front transport mechanism configured to transport a substrate to each of the processing units of the second front portion,
the slider portion overlaps with the processing units of the second front portion in plan view, and
the slider portion is disposed between the first front portion and the second front portion.

11. The substrate processing apparatus according to claim 10, wherein
the slider portion includes:
a lower portion; and
an upper portion located upward of the lower portion of the slider portion,
the first front transport mechanism is configured to move to a height position same as a height position of the lower portion of the slider portion, and
the second front transport mechanism is configured to move to a height position same as a height position of the upper portion of the slider portion.

12. The substrate processing apparatus according to claim 11, wherein
the processing units of the second front portion include:
a first processing unit; and
a plurality of second processing units,
the first processing unit of the second front portion is disposed upward of the first processing unit of the first front portion,
the slider portion is disposed upward of the first processing unit of the first front portion and downward of the first processing unit of the second front portion,
the second processing units of the second front portion are disposed upward of the second processing units of the first front portion,
the second processing units of the second front portion are arranged in a vertical direction,
at least one of the second processing units of the first front portion is disposed at a height position same as a height position of the lower portion of the slider portion, and
at least one of the second processing units of the second front portion is disposed at a height position same as a height position of the upper portion of the slider portion.

13. The substrate processing apparatus according to claim 1, wherein
the indexer portion includes a first transport mechanism,
the slider portion includes a second transport mechanism,
the bridge portion includes a third transport mechanism,
the first transport mechanism and the second transport mechanism deliver a substrate to each other,
the second transport mechanism and the third transport mechanism deliver a substrate to each other,
the first transport mechanism includes a first support portion configured to support a substrate,
the second transport mechanism includes a second support portion configured to support a substrate,
the third transport mechanism includes a third support portion configured to support a substrate, and
when the first transport mechanism and the second transport mechanism deliver a substrate to each other, the second support portion overlaps with the processing units of the first front portion in plan view.

14. The substrate processing apparatus according to claim 13, wherein
when the second transport mechanism and the third transport mechanism deliver a substrate to each other, the second support portion overlaps with the processing units of the first front portion in plan view.

15. The substrate processing apparatus according to claim 13, wherein
the first transport mechanism and the second transport mechanism deliver a plurality of substrates to each other at a time, and
the second transport mechanism and the third transport mechanism deliver a plurality of substrates to each other at a time.

16. The substrate processing apparatus according to claim 15, wherein
the first support portion includes a plurality of first hands,
each of the first hands supports one substrate,
the second support portion includes a plurality of second hands,
each of the second hands supports one substrate,
the third support portion includes a plurality of third hands, and
each of the third hands supports one substrate.

17. The substrate processing apparatus according to claim 13, wherein
the second transport mechanism includes a guide configured to guide the second support portion,
the guide has a closed curved shape, and
the second support portion circularly moves along the guide.

18. The substrate processing apparatus according to claim 13, wherein
the slider portion includes a substrate position sensor configured to detect a position of a substrate supported by the second support portion.

19. The substrate processing apparatus according to claim 18, wherein
the substrate position sensor is unmovable, and
the substrate position sensor detects a position of a substrate supported by the second support portion when the second transport mechanism transports a substrate.

20. The substrate processing apparatus according to claim 18, comprising:
a controller configured to control at least one of the first transport mechanism, the second transport mechanism, or the third transport mechanism based on a detection result of the substrate position sensor.

21. The substrate processing apparatus according to claim 13, wherein
the slider portion includes an inspection portion configured to inspect a substrate supported by the second support portion.

22. The substrate processing apparatus according to claim 21, wherein
the inspection portion is unmovable, and
the inspection portion inspects a substrate supported by the second support portion when the second transport mechanism transports a substrate.

23. A substrate processing method comprising:
transporting a substrate from an indexer portion to a slider portion;
transporting a substrate from the slider portion to a bridge portion;
transporting a substrate from the bridge portion to a first front portion;
transporting a substrate from the bridge portion to a first rear portion;
transporting a substrate to a processing unit of the first front portion by using a first front transport mechanism of the first front portion, the processing unit overlapping with the slider portion in plan view; and
transporting a substrate to a processing unit of the first rear portion by using a first rear transport mechanism of the first rear portion.

24. The substrate processing method according to claim 23, comprising:
transporting a substrate from the first front portion to the bridge portion;
transporting a substrate from the first rear portion to the bridge portion;
transporting a substrate from the bridge portion to the slider portion; and
transporting a substrate from the slider portion to the indexer portion.
